# EUROPEAN PATENT APPLICATION

(11) **EP 4 801 219 A1**
(43) Date of publication of application: **02.09.2026**
(21) Application number: 25206957.0
(22) Date of filing: 06.10.2025
(51) Int. Cl.: H10B 12/00

(54) **SEMICONDUCTOR DEVICE AND METHOD FOR MANUFATURING THE SAME**

(30) Priority: 26.02.2025 KR 20250025153
(71) Applicant: SK hynix Inc., Bubal-eub Icheon-si Gyeonggi-do 17336 (KR)
(72) Inventor: NAM, Yoon Jae, Icheon-si, Gyeonggi-do (KR); BAEK, Seung Beom, Icheon-si, Gyeonggi-do (KR)
(74) Representative: Isarpatent

(57) **Abstract**

A semiconductor device and a method for manufacturing the same are disclosed. The semiconductor device includes a word-line structure extending into a semiconductor layer to a first depth, and additionally extending in a first direction, an active region extending in a diagonal direction with respect to the first direction in the semiconductor layer, and overlapping with the word-line structure, a bit-line pad region overlapping with one end of the active region and contacting one side of the word-line structure, and extending into the semiconductor layer to a second depth that is shallower than the first depth, and a storage-node pad region overlapping with another end of the active region and contacting another side of the word-line structure, the storage-node pad region being spaced apart from the bit-line pad region in the diagonal direction and extending into the semiconductor layer to a third depth that is shallower than the first depth.

## Description

### TECHNICAL FIELD

The technology and embodiments of the present disclosure generally relate to a semiconductor device and a method for manufacturing the same, and more particularly to a semiconductor device including a plurality of active regions.

### BACKGROUND

A semiconductor device capable of memory functionality may incorporate an array of individual memory cells, each comprising transistors for information storage. Among such devices, dynamic random access memory (DRAM) serves as a prime example. DRAM is structured with intersecting bit lines and word lines oriented vertically, spanning the array of memory cells. These lines facilitate access to individual memory cells, enabling efficient data retrieval and storage.

Memory performance, cell stability, reliability, power efficiency, ease of processing, and cost may vary depending on the design and how the individual memory cells are configured. Research on cell array design of memory devices and fabrication processes of the cell arrays remain active. As technological demands continue to evolve, further developments and innovations are essential to meet the growing needs of modem computing.

### SUMMARY

Various embodiments of the present disclosure relate to a semiconductor device having reduced contact resistance between a bit-line contact and a storage-node contact.

Various embodiments of the present disclosure relate to a semiconductor device having reduced contact resistance between a bit-line contact and a storage-node contact, and a method for manufacturing the semiconductor device, so that a fabrication process of the semiconductor device can be simplified and production costs of the semiconductor device can be reduced.

In accordance with an embodiment of the present disclosure, a semiconductor device may include a semiconductor layer; a first word-line structure recessed from a surface of the semiconductor layer into the semiconductor layer by a first depth, and configured to extend in a first direction; a first active region disposed in the semiconductor layer and extending in a diagonal direction with respect to the first direction, and configured to overlap with the first word-line structure; a first bit-line pad region configured to overlap with one end of the first active region and contact one side of the first word-line structure, and configured to be recessed from the surface of the semiconductor layer into the semiconductor layer by a second depth shallower than the first depth; and a first storage-node pad region configured to overlap another end of the first active region and contact another side of the first word-line structure, and configured to be spaced apart from the first bit-line pad region in the diagonal direction.

In some embodiments, the first storage-node pad region may be recessed from the surface of the semiconductor layer by a third depth.

In some embodiments, the second depth may be identical to the third depth.

In some embodiments, the semiconductor device may further include a first bit-line contact region disposed on the surface of the semiconductor layer, and configured to contact the first bit-line pad region; and a first storage-node contact region disposed on the surface of the semiconductor layer, and configured to contact the first storage-node pad region.

In some embodiments, the semiconductor device may further include a first bit-line electrode layer disposed on the first bit-line contact region, configured to overlap with the first bit-line pad region, and extend in a second direction; and a first bit-line spacer configured to contact both side surfaces of the first bit-line electrode layer, and extend in the second direction.

In some embodiments, the second direction may be perpendicular to the first direction.

In some embodiments, an angle formed between the diagonal direction and the first direction may be an acute angle; and an angle formed between the diagonal direction and the second direction may be an acute angle.

In some embodiments, the semiconductor device may further include a second active region disposed in the semiconductor layer, configured to extend in the diagonal direction, be spaced apart from the first active region in the first direction, and overlap with the first word-line structure; a second bit-line pad region configured to overlap with one end of the second active region and contact the one side of the first word-line structure, and be recessed from the surface of the semiconductor layer into the semiconductor layer by the second depth; and a second storage-node pad region configured to overlap another end of the second active region and contact the other side of the first word-line structure, and be spaced apart from the second bit-line pad region in the diagonal direction.

In some embodiments, the semiconductor device may further include a second bit-line contact region disposed on the surface of the semiconductor layer, and configured to contact the second bit-line pad region; and a second storage-node contact region disposed on the surface of the semiconductor layer, and configured to contact the second storage-node pad region.

In some embodiments, the semiconductor device may further include a second bit-line electrode layer disposed on the second bit-line contact region, configured to overlap with the second bit-line pad region, and extend in a second direction; and a second bit-line spacer configured to contact both side surfaces of the second bit-line electrode layer, and extend in the second direction.

In some embodiments, the semiconductor device may further include a second word-line structure recessed from the surface of the semiconductor layer into the semiconductor layer, configured to extend in the first direction, and be spaced apart from the first word-line structure in the second direction; a third active region disposed in the semiconductor layer, configured to extend in the diagonal direction, be spaced apart from the first active region in the diagonal direction, and overlap with the second word-line structure; a third bit-line pad region configured to overlap with one end of the third active region, contact one side of the second word-line structure, and be recessed from the surface of the semiconductor layer into the semiconductor layer by the second depth; and a third storage-node pad region configured to overlap another end of the third active region, contact another side of the second word-line structure, and be spaced apart from the second bit-line pad region in the diagonal direction.

In some embodiments, the semiconductor device may further include a third bit-line contact region disposed on the surface of the semiconductor layer, and configured to contact the third bit-line pad region; and a third storage-node contact region disposed on the surface of the semiconductor layer, and configured to contact the third storage-node pad region.

In some embodiments, the second bit-line electrode layer may be disposed on the third bit-line contact region, and overlaps the second bit-line pad region.

In some embodiments, an angle formed between the diagonal direction and the first direction may be in a range of 30 degrees to 60 degrees.

In some embodiments, each of the first bit-line pad region and the first storage-node pad region may include polysilicon.

In accordance with another embodiment of the present disclosure, a method for manufacturing a semiconductor device may include forming a plurality of active regions that is arranged to be repeatedly spaced apart from each other in a first direction and a second direction within a semiconductor layer and extends in a diagonal direction with respect to the first direction; forming a plurality of pad trenches, each of which overlaps the plurality of active regions spaced apart from each other in the first direction and extends in the second direction; forming a plurality of pad regions, each of which contacts side surfaces of the plurality of pad trenches and extends in the second direction; forming a plurality of pad insulation regions, each of which extends in the second direction at a central portion of the plurality of pad trenches and electrically isolates the plurality of pad regions from each other; and forming a plurality of word-line structures that overlaps a central portion of the plurality of active regions arranged in the first direction, extends in the first direction, and is repeatedly spaced apart from each other in the second direction.

In some embodiments, forming the plurality of word-line structures may include forming the plurality of word-line structures recessed from a surface of the semiconductor layer by a first depth, and forming the plurality of pad trenches may include forming the plurality of pad trenches that is recessed from a surface of the semiconductor layer by a second depth shallower than the first depth.

In some embodiments, forming the plurality of word-line structures may include removing a portion of each of the plurality of pad regions.

In some embodiments, the method may further include forming a plurality of bit-line contact regions, each of which overlaps one end of each of the plurality of active regions and is disposed on pad regions that contact one end of each of the plurality of word-line structures; and forming a plurality of storage-node contact regions, each of which overlaps another end of each of the plurality of active regions and is disposed on pad regions that contact another end of each of the plurality of word-line structures.

In some embodiments, the method may further include forming a plurality of bit-line electrode layers that overlaps the plurality of bit-line contact regions, extends in the second direction, and is arranged to be repeatedly spaced apart from each other in the first direction.

It is to be understood that both the foregoing general description and the following detailed description of the embodiments of the present disclosure are illustrative and are intended to provide further description of the embodiments as claimed.

### BRIEF DESCRIPTION OF THE DRAWINGS

The above and other features and beneficial aspects of the embodiments of the present disclosure will become readily apparent with reference to the following detailed description when considered in conjunction with the accompanying drawings.
FIG. 1 is a circuit diagram illustrating a modeling circuit of a unit cell of a semiconductor device according to some embodiments of the present disclosure.
FIG. 2 is a first plan view illustrating a section of a semiconductor device according to some embodiments of the present disclosure.
FIG. 3 is a second plan view illustrating a section of a semiconductor device according to some embodiments of the present disclosure.
FIG. 4 is a cross-sectional view illustrating a structure of the semiconductor device taken along the line A-A' of FIGS. 2 and 3 according to some embodiments of the present disclosure.
FIG. 5 is a cross-sectional view illustrating a structure of the semiconductor device taken along the line B-B' of FIGS. 2 and 3 according to some embodiments of the present disclosure.
FIG. 6 is a cross-sectional view illustrating a structure of the semiconductor device taken along the line C-C' of FIGS. 2 and 3 according to some embodiments of the present disclosure.
FIG. 7 is a cross-sectional view illustrating a structure of the semiconductor device taken along the line D-D' of FIGS. 2 and 3 according to some embodiments of the present disclosure.
FIG. 8 is a cross-sectional view illustrating a structure of the semiconductor device taken along the line E-E' of FIGS. 2 and 3 according to some embodiments of the present disclosure.
FIG. 9 is a flowchart illustrating a method for manufacturing a semiconductor device according to some embodiments of the present disclosure.
FIG. 10A is a plan view illustrating a result of performing operation S10 of FIG. 9 according to some embodiments of the present disclosure.
FIG. 10B is a cross-sectional view illustrating a structure of the semiconductor device taken along the line A-A' of FIG. 10A according to some embodiments of the present disclosure.
FIG. 10C is a cross-sectional view illustrating a structure of the semiconductor device taken along the line B-B' of FIG. 10A according to some embodiments of the present disclosure.
FIG. 10D is a cross-sectional view illustrating a structure of the semiconductor device taken along the line C-C' of FIG. 10A according to some embodiments of the present disclosure.
FIG. 10E is a cross-sectional view illustrating a structure of the semiconductor device taken along the line D-D' of FIG. 10A according to some embodiments of the present disclosure.
FIG. 10F is a cross-sectional view illustrating a structure of the semiconductor device taken along the line E-E' of FIG. 10A according to some embodiments of the present disclosure.
FIG. 11A is a plan view illustrating a result of performing operation S20 of FIG. 9 according to some embodiments of the present disclosure.
FIG. 11B is a cross-sectional view illustrating a structure of the semiconductor device taken along the line A-A' of FIG. 11A according to some embodiments of the present disclosure.
FIG. 11C is a cross-sectional view illustrating a structure of the semiconductor device taken along the line B-B' of FIG. 11A according to some embodiments of the present disclosure.
FIG. 11D is a cross-sectional view illustrating a structure of the semiconductor device taken along the line C-C' of FIG. 11A according to some embodiments of the present disclosure.
FIG. 11E is a cross-sectional view illustrating a structure of the semiconductor device taken along the line D-D' of FIG. 11A according to some embodiments of the present disclosure.
FIG. 11F is a cross-sectional view illustrating a structure of the semiconductor device taken along the line E-E' of FIG. 11A according to some embodiments of the present disclosure.
FIG. 12A is a plan view illustrating a result of performing operation S30 of FIG. 9 according to some embodiments of the present disclosure.
FIG. 12B is a cross-sectional view illustrating a structure of the semiconductor device taken along the line A-A' of FIG. 12A according to some embodiments of the present disclosure.
FIG. 12C is a cross-sectional view illustrating a structure of the semiconductor device taken along the line B-B' of FIG. 12A according to some embodiments of the present disclosure.
FIG. 12D is a cross-sectional view illustrating a structure of the semiconductor device taken along the line C-C' of FIG. 12A according to some embodiments of the present disclosure.
FIG. 12E is a cross-sectional view illustrating a structure of the semiconductor device taken along the line D-D' of FIG. 12A according to some embodiments of the present disclosure.
FIG. 12F is a cross-sectional view illustrating a structure of the semiconductor device taken along the line E-E' of FIG. 12A according to some embodiments of the present disclosure.
FIG. 13A is a plan view illustrating a result of performing operation S40 of FIG. 9 according to some embodiments of the present disclosure.
FIG. 13B is a cross-sectional view illustrating a structure of the semiconductor device taken along the line A-A' of FIG. 13A according to some embodiments of the present disclosure.
FIG. 13C is a cross-sectional view illustrating a structure of the semiconductor device taken along the line B-B' of FIG. 13A according to some embodiments of the present disclosure.
FIG. 13D is a cross-sectional view illustrating a structure of the semiconductor device taken along the line C-C' of FIG. 13A according to some embodiments of the present disclosure.
FIG. 13E is a cross-sectional view illustrating a structure of the semiconductor device taken along the line D-D' of FIG. 13A according to some embodiments of the present disclosure.
FIG. 13F is a cross-sectional view illustrating a structure of the semiconductor device taken along the line E-E' of FIG. 13A according to some embodiments of the present disclosure.
FIG. 14A is a plan view illustrating a result of performing operation S50 of FIG. 9 according to some embodiments of the present disclosure.
FIG. 14B is a cross-sectional view illustrating a structure of the semiconductor device taken along the line A-A' of FIG. 14A according to some embodiments of the present disclosure.
FIG. 14C is a cross-sectional view illustrating a structure of the semiconductor device taken along the line B-B' of FIG. 14A according to some embodiments of the present disclosure.
FIG. 14D is a cross-sectional view illustrating a structure of the semiconductor device taken along the line C-C' of FIG. 14A according to some embodiments of the present disclosure.
FIG. 14E is a cross-sectional view illustrating a structure of the semiconductor device taken along the line D-D' of FIG. 14A according to some embodiments of the present disclosure.
FIG. 14F is a cross-sectional view illustrating a structure of the semiconductor device taken along the line E-E' of FIG. 14A according to some embodiments of the present disclosure.
FIG. 15A is a plan view illustrating a result of performing operation S60 of FIG. 9 according to some embodiments of the present disclosure.
FIG. 15B is a cross-sectional view illustrating a structure of the semiconductor device taken along the line A-A' of FIG. 15A according to some embodiments of the present disclosure.
FIG. 15C is a cross-sectional view illustrating a structure of the semiconductor device taken along the line B-B' of FIG. 15A according to some embodiments of the present disclosure.
FIG. 15D is a cross-sectional view illustrating a structure of the semiconductor device taken along the line C-C' of FIG. 15A according to some embodiments of the present disclosure.
FIG. 15E is a cross-sectional view illustrating a structure of the semiconductor device taken along the line D-D' of FIG. 15A according to some embodiments of the present disclosure.
FIG. 15F is a cross-sectional view illustrating a structure of the semiconductor device taken along the line E-E' of FIG. 15A according to some embodiments of the present disclosure.
FIG. 16A is a plan view illustrating an example result of performing operation S70 of FIG. 9 according to some embodiments of the present disclosure.
FIG. 16B is a cross-sectional view illustrating a structure of the semiconductor device taken along the line A-A' of FIG. 16A according to some embodiments of the present disclosure.
FIG. 16C is a cross-sectional view illustrating a structure of the semiconductor device taken along the line B-B' of FIG. 16A according to some embodiments of the present disclosure.
FIG. 16D is a cross-sectional view illustrating a structure of the semiconductor device taken along the line C-C' of FIG. 16A according to some embodiments of the present disclosure.
FIG. 16E is a cross-sectional view illustrating a structure of the semiconductor device taken along the line D-D' of FIG. 16A according to some embodiments of the present disclosure.
FIG. 16F is a cross-sectional view illustrating a structure of the semiconductor device taken along the line E-E' of FIG. 16A according to some embodiments of the present disclosure.
FIG. 17A is a plan view illustrating a result of performing operation S80 of FIG. 9 according to some embodiments of the present disclosure.
FIG. 17B is a cross-sectional view illustrating a structure of the semiconductor device taken along the line A-A' of FIG. 17A according to some embodiments of the present disclosure.
FIG. 17C is a cross-sectional view illustrating a structure of the semiconductor device taken along the line B-B' of FIG. 17A according to some embodiments of the present disclosure.
FIG. 17D is a cross-sectional view illustrating a structure of the semiconductor device taken along the line C-C' of FIG. 17A according to some embodiments of the present disclosure.
FIG. 17E is a cross-sectional view illustrating a structure of the semiconductor device taken along the line D-D' of FIG. 17A according to some embodiments of the present disclosure.
FIG. 17F is a cross-sectional view illustrating a structure of the semiconductor device taken along the line E-E' of FIG. 17A according to some embodiments of the present disclosure.
FIG. 18A is a plan view illustrating a result of performing operation S90 of FIG. 9 according to some embodiments of the present disclosure.
FIG. 18B is a cross-sectional view illustrating a structure of the semiconductor device taken along the line A-A' of FIG. 18A according to some embodiments of the present disclosure.
FIG. 18C is a cross-sectional view illustrating a structure of the semiconductor device taken along the line B-B' of FIG. 18A according to some embodiments of the present disclosure.
FIG. 18D is a cross-sectional view illustrating a structure of the semiconductor device taken along the line C-C' of FIG. 18A according to some embodiments of the present disclosure.
FIG. 18E is a cross-sectional view illustrating a structure of the semiconductor device taken along the line D-D' of FIG. 18A according to some embodiments of the present disclosure.
FIG. 18F is a cross-sectional view illustrating a structure of the semiconductor device taken along the line E-E' of FIG. 18A according to some embodiments of the present disclosure.

### DETAILED DESCRIPTION

The present disclosure provides embodiments and examples of a semiconductor device including a plurality of active regions and a method for manufacturing the same that may be used in configurations to substantially address one or more technical or engineering issues and to mitigate limitations or disadvantages encountered in some semiconductor devices in the art. Some embodiments of the present disclosure relate to a semiconductor device having reduced contact resistance between a bit-line contact and a storage-node contact. Some embodiments of the present disclosure relate to a semiconductor device having reduced contact resistance between a bit-line contact and a storage-node contact, and a method for manufacturing the semiconductor device, so that a fabrication process of the semiconductor device can be simplified and production costs of the semiconductor device can be reduced. In recognition of the issues above, the semiconductor device according to some embodiments of the present disclosure can facilitate a fabrication process of bit-line contacts and storage-node contacts, thereby securing necessary resistance. The semiconductor device according to some embodiments of the present disclosure includes a pad region disposed between the bit-line contact and the active region and another pad region disposed between the storage-node contact and the active region, resulting in reduction in contact resistance. Some embodiments of the present disclosure relate to a method for manufacturing the semiconductor device, which can reduce production costs of the semiconductor device, and can simplify the fabrication process (i.e., can reduce the number of fabrication steps) of the semiconductor device.

Reference will now be made in detail to the embodiments of the present disclosure, examples of which are illustrated in the accompanying drawings. Wherever possible, the same reference numbers will be used throughout the drawings to refer to the same or like parts. While the present disclosure is susceptible to various modifications and alternative forms, specific embodiments thereof are shown by way of example in the drawings. However, the embodiments of the present disclosure should not be construed as being limited to the embodiments set forth herein.

Hereinafter, various embodiments will be described with reference to the accompanying drawings. However, it should be understood that the embodiments of the present disclosure are not limited to the specific embodiments illustrated, but include various modifications, equivalents and/or alternatives of the embodiments. The embodiments of the present disclosure may provide a variety of advantageous effects capable of being directly or indirectly recognized.

In describing the components of the embodiments of the present disclosure, various terms such as first, second, etc., may be used solely for the purpose of differentiating one component from another, but the essence, order and sequence of the components are not limited to these terms. Unless defined otherwise, all terms, including technical and scientific terms, used in the present disclosure may have the same meaning as commonly understood by a person having ordinary skill in the art to which the present disclosure pertains. It will be further understood that terms, such as those defined in commonly used dictionaries, may be interpreted as having a meaning that is consistent with their meaning in the context of the related art and the present disclosure, and should not be interpreted in an idealized or overly formal sense unless expressly so defined herein.

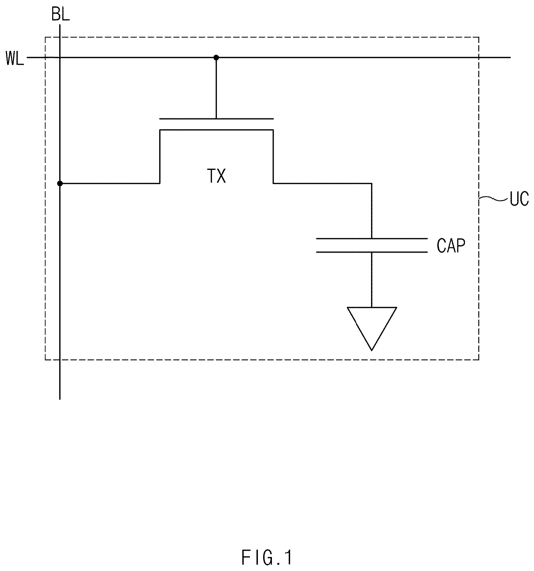

FIG. 1 is a circuit diagram illustrating a modeling circuit of a unit cell (UC) of a semiconductor device according to some embodiments of the present disclosure.

Referring to FIG. 1, the unit cell (UC) of the semiconductor device according to an embodiment of the present disclosure may include a transistor (TX) and a capacitor (CAP). The unit cell (UC) may be a unit that stores data in the semiconductor device. The semiconductor device according to an embodiment of the present disclosure may function as a data storage device that may be included in various electronic devices such as computers. In some embodiments, the semiconductor device may be a volatile memory device (e.g., a dynamic random access memory (DRAM)) or a non-volatile memory device (e.g., a NAND memory).

The transistor (TX) may be a switching element between a bit line (BL) and a capacitor (CAP). The transistor (TX) may be, for example, a metal oxide semiconductor field effect transistor (MOSFET). The transistor (TX) may operate with an electric field generated by a voltage applied to a gate terminal thereof. When the transistor (TX) is turned on, the bit line (BL) and the capacitor (CAP) may be electrically connected to each other. When the transistor (TX) is turned off, electrical connection between the bit line (BL) and the capacitor (CAP) may be prevented.

The word line (WL) may adjust (control) on/off states of the transistor (TX). For example, when a word-line signal applied to the word line (WL) has a logic high level, the transistor (TX) may be turned on. On the other hand, when the word-line signal applied to the word line (WL) has a logic low level, the transistor (TX) may be turned off.

The bit line (BL) may be an interconnect structure designed to transmit data. The bit line (BL) may transfer charges to the capacitor (CAP) when the transistor (TX) is turned on. When the bit-line signal applied to the bit line (BL) has a high level and the transistor (TX) is turned on, data "1" may be stored in the capacitor (CAP). When the bit-line signal applied to the bit line (BL) has a low level and the transistor (TX) is turned on, data "0" may be stored in the capacitor (CAP).

A capacitor (CAP) may be a storage device that stores data. For example, the second capacitor (CAP) may include at least one of a Metal-Insulator-Metal (MIM) capacitor, a Metal-Oxide-Metal (MOM) capacitor, or a Metal-Oxide-Semiconductor (MOS) capacitor, without being limited thereto. When the capacitor (CAP) stores charges of a predetermined level or higher, the unit cell (UC) may be in a state of storing data "1". When the capacitor (CAP) stores charges of a predetermined level or less, the unit cell (UC) may be in a state of storing data "0".

In an operation of writing data "1" to the unit cell (UC), a bit-line signal of a high level may be applied to the bit line (BL), and a word-line signal of a high level may be applied to the word line (WL). When the transistor (TX) is turned on by the high-level word-line signal, the bit line (BL) may serve as a drain terminal of the transistor (TX), the capacitor (CAP) may serve as a source terminal of the transistor (TX), and a potential level of the capacitor (CAP) may increase by the high-level bit-line signal, so that data "1" can be written to the unit cell (UC).

In an operation of writing data "0" to the unit cell (UC), a bit-line signal of a low level may be applied to the bit line (BL), and a word-line signal of a high level may be applied to the word line (WL). When the transistor (TX) is turned on, the bit line (BL) may serve as a source terminal of the transistor (TX), and the capacitor (CAP) may serve as drain terminal, and a potential level of the capacitor (CAP) may decrease by the low-level bit-line signal, so that data "0" can be written to the unit cell (UC).

In an operation of reading data of the unit cell (UC), the bit-line signal may have a reference level located between the high level and the low level, and the word-line signal may have a high level. When data "1" is written (stored) to the unit cell (UC) and the transistor (TX) is turned on, the potential level of the capacitor (CAP) is at a high level, so that the level of the bit-line signal may become higher than the reference level. When data "0" is recorded in the unit cell (UC) and the transistor (TX) is turned on, the potential level of the capacitor (CAP) is at a low level, so that the level of the bit-line signal may become lower than the reference level. The semiconductor device may determine whether the level of the bit-line signal becomes higher than the reference level, and may read data of the unit cell (UC) based on the result of the determination.

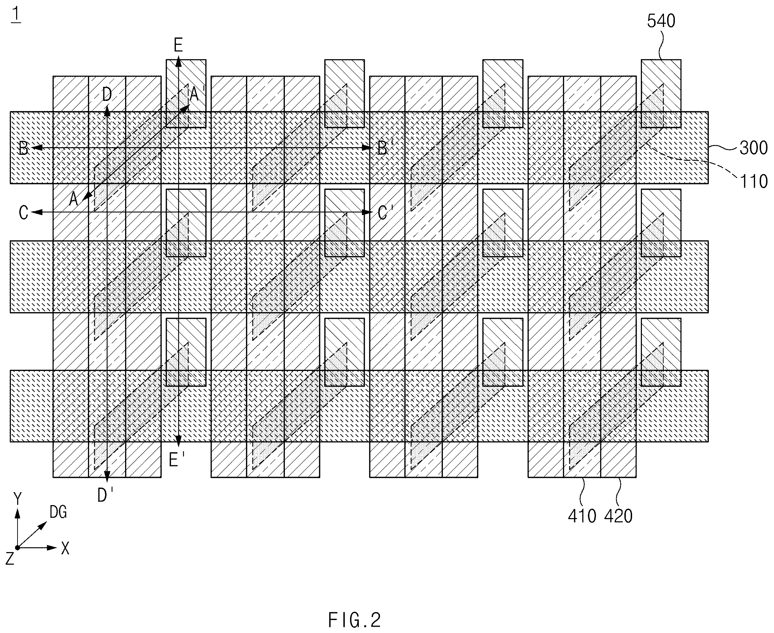

FIG. 2 is a first plan view illustrating a section of a semiconductor device 1 according to some embodiments of the present disclosure.

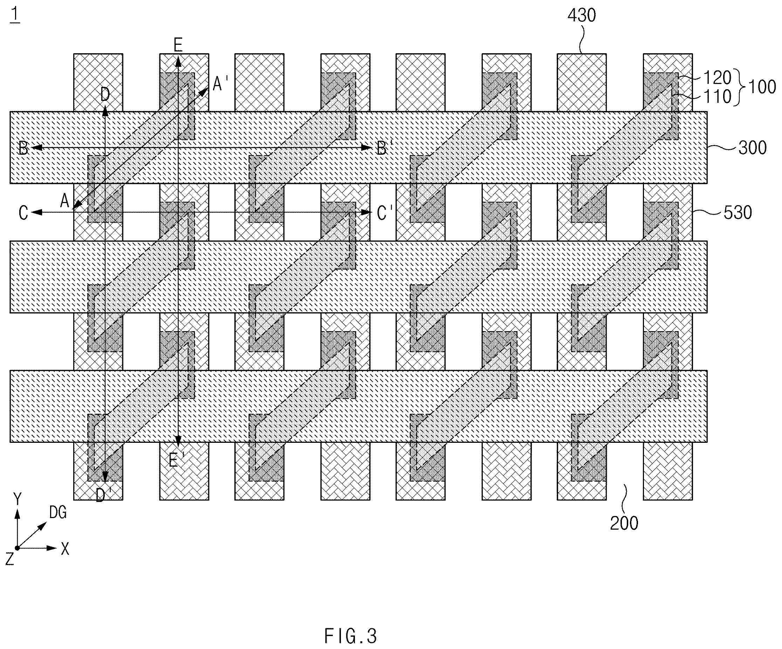

FIG. 3 is a second plan view illustrating a section of the semiconductor device according to some embodiments of the present disclosure.

Referring to FIGS. 1, 2, and 3, the first plan view and the second plan view are plan views showing the positional relationship between a plurality of main active regions 110 and peripheral structures according to some embodiments. The first plan view is a plan view showing the positional relationship between the plurality of main active regions 110 and peripheral structures arranged on a surface of a predetermined semiconductor substrate. The second plan view is a plan view showing the positional relationship between the plurality of main active regions 110 and peripheral structures arranged below the surface of the predetermined semiconductor substrate. The semiconductor device 1 may include a plurality of active regions 100, a cell isolation region 200, a plurality of word-line structures 300, a plurality of bit-line electrode layers 410, a plurality of bit-line spacers 420, a plurality of bit-line pad regions 430, a plurality of storage-node pad regions 530, and a plurality of storage-node contact regions 540.

Each of the plurality of active regions 100 may include a semiconductor material (e.g., silicon (Si), silicon carbide (SiC), etc.). Each of the plurality of active regions 100 may be surrounded by a cell isolation region 200. For example, the plurality of active regions 100 may be arranged in a matrix structure. The plurality of active regions 100 may be arranged in an (m × n) matrix structure, where 'm' is an integer greater than or equal to 2, and 'n' is an integer greater than or equal to 2. Each of the plurality of active regions 100 may extend in a diagonal direction (DG). The diagonal direction (DG) may be a diagonal direction with respect to a first direction (X). Some of the plurality of active regions 100 may be repeatedly arranged spaced apart from each other in the first direction (X). Some of the plurality of active regions 100 may be repeatedly arranged spaced apart from each other in a second direction (Y) perpendicular to the first direction (X). Some of the plurality of active regions 100 may be repeatedly arranged spaced apart from each other in a diagonal direction (DG). An angle formed by the diagonal direction (DG) and the first direction (X) may be an acute angle. An angle formed by the diagonal direction (DG) and the second direction (Y) may be an acute angle. An acute angle formed by the first direction (X) and the diagonal direction (DG) may be in a range of about 30 degrees to about 60 degrees. Each of the plurality of active regions 100 may overlap with the word-line structure 300. Each of the plurality of active regions 100 may include a main active region 110 and a sub-active region 120.

The main active region 110 may be a semiconductor region extending in the diagonal direction (DG). The sub-active region 120 may be a semiconductor region surrounding both ends of the main active region 110. Although the main active region 110 is illustrated in a shape like a parallelogram, the scope of the present disclosure is not limited thereto. For example, each of the four corner regions of the main active region 110 may have a round shape. Although the sub-active region 120 is illustrated as having a rectangular shape, the sub-active region 120 is not limited thereto. For example, the sub-active region 120 may have a shape formed by performing epitaxial growth from each of both ends of the main active region 110.

The main active region 110 may include a region in which a channel of the transistor (TX) of the unit cell (UC) is formed. For example, the sub-active region 120 surrounding one end of the main active region 110 may overlap a bit-line electrode layer 410 to which the bit-line signal of the bit line (BL) is applied. For example, the sub-active region 120 surrounding the other end of the main active region 110 may overlap a storage-node contact region 540 and a storage-node pad region 530 that are connected to the capacitor (CAP).

The cell isolation region 200 may include an insulation material, such as, for example, at least one of silicon oxide or a Silicon-On-Insulator (SOI) structure. The cell isolation region 200 may surround each of the plurality of active regions 100. The cell isolation region 200 may be positioned between the spaced apart active regions 100 for providing electrical insulation between the plurality of the spaced apart active regions 100.

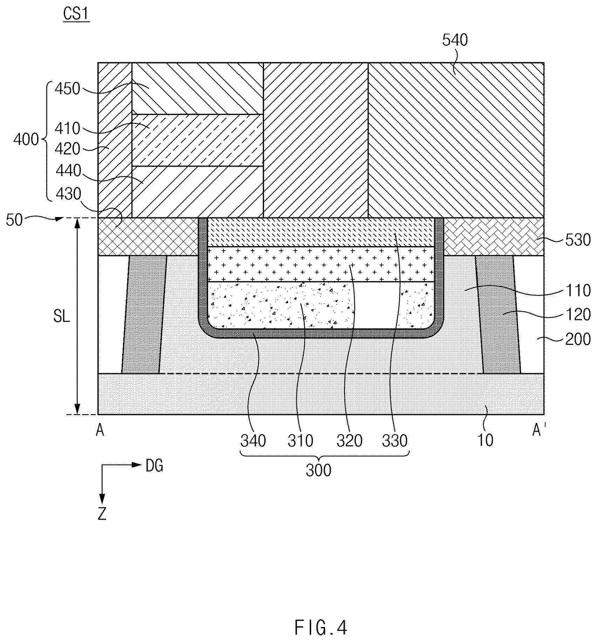

Each of the plurality of word-line structures 300 may extend in the first direction (X). Each of the plurality of word-line structures 300 may be arranged spaced apart from each other in the second direction (Y). Each of the plurality of word-line structures 300 may include a predetermined electrode layer to which a word-line signal is applied. When the word-line signal has a high level in an electrode layer included in the word-line structure 300, a predetermined channel may be formed within the active region 100 overlapping the word-line structure 300. Each of the plurality of word-line structures 300 may overlap each of the plurality of active regions 100 spaced apart from each other in the first direction (X). Although each of the plurality of word-line structures 300 may be formed to pass through the center of each of the plurality of active regions 100 spaced apart from each other in the first direction (X), other embodiments are also possible, and the structure of the plurality of word-line structures 300 may vary depending on fabrication limitations and variables, other embodiments are also possible, and the design and configuration of the word-line structures 300 may vary depending on fabrication limitations and variables in a fabrication process. When misalignment occurs in a masking pattern for forming the word-line structures 300, each of the word-line structures 300 may be formed to be biased (offset) to one side from the center of each of the active regions 100. As the center of each word-line structure 300 extends in the first direction (X) closer to the center of the active region 100, the reliability of the semiconductor device 1 can be improved. The internal structure of the word-line structures 300 will be described with reference to FIG. 4 and below.

Each of the plurality of bit-line electrode layers 410 may include a conductive material. For example, each of the plurality of bit-line electrode layers 410 may include a metal material such as aluminum (Al), copper (Cu), or tungsten (W). Each of the plurality of bit-line electrode layers 410 may extend in the second direction (Y). Each of the plurality of bit-line electrode layers 410 may be arranged spaced apart from each other in the first direction (X). The first direction (X) and the second direction (Y) may be perpendicular to each other. Each of the plurality of bit-line electrode layers 410 may be an electrode layer to which the bit-line signal is applied. Each of the plurality of bit-line electrode layers 410 may overlap with the plurality of bit-line pad regions 430 spaced apart from each other in the second direction (Y). Each of the plurality of bit-line electrode layers 410 may intersect (cross) the plurality of word-line structures 300. Both side surfaces of each of the plurality of bit-line electrode layers 410 may contact the bit-line spacer 420. Each of the plurality of bit-line electrode layers 410 may overlap with one end of each active region 100.

Each of the plurality of bit-line spacers 420 may include an insulation material. For example, each of the plurality of bit-line spacers 420 may include an insulation material such as silicon oxide or silicon nitride. Each of the plurality of bit-line spacers 420 may extend in the second direction (Y). The plurality of bit-line spacers 420 may be arranged spaced apart from each other in the first direction (X). The plurality of bit-line spacers 420 may prevent electrical interaction between the bit-line electrode layers 410 spaced apart from each other. The plurality of bit-line spacers 420 may form one pair, and one pair of the bit-line spacers 420 may contact both side surfaces of the bit-line electrode layer 410 and may surround both side surfaces of the bit-line electrode layer 410.

Each of the plurality of bit-line pad regions 430 may include a conductive material. For example, each of the plurality of bit-line pad regions 430 may include polysilicon. For example, the polysilicon may include predetermined impurities for improving conductivity. Each of the plurality of bit-line pad regions 430 may be configured to properly transmit a bit-line signal applied to the bit-line electrode layer 410 to the active region 100. Each of the plurality of bit-line pad regions 430 may be arranged between two adjacent word-line structures 300. For example, each of the plurality of bit-line pad regions 430 may contact both side surfaces of the two adjacent word-line structures 300 facing each other. The bit-line pad region 430 may overlap with one end of the active region 100. The bit-line pad region 430 may overlap with one end of the main active region 110 and the sub-active region 120 surrounding the one end. In an arbitrary active region 100, the bit-line pad region 430 may contact one side of the word-line structure 300 overlapping the active region 100. The bit-line pad region 430 may also contact a word-line structure 300 overlapping the active region 100 that is spaced apart from the active region 100 in a direction opposite to the second direction (Y). Some of the plurality of bit-line pad regions 430 may be arranged spaced apart from each other in the first direction (X). Some others of the plurality of bit-line pad regions 430 may be arranged spaced apart from each other in the second direction (Y).

Each of the plurality of storage-node pad regions 530 may include a conductive material. For example, each of the plurality of storage-node pad regions 530 may include polysilicon. The polysilicon may also include predetermined impurities for improving conductivity. The storage-node pad region 530 may include the same material as the bit-line pad region 430. Each of the plurality of storage-node pad regions 530 may be disposed between two adjacent word-line structures 300. For example, each of the plurality of storage-node pad regions 530 may contact both side surfaces of the two adjacent word-line structures 300 facing each other. The storage-node pad region 530 may overlap with the other end facing or opposite to the one end of the active region 100. The storage-node pad region 530 may overlap with the other end of a main active region 110 and a sub-active region 120 surrounding the other end of the main active region 110. In an arbitrary active region 100, the storage-node pad region 530 may contact one side of the word-line structure 300 overlapping the active region 100. The storage-node pad region 530 may also contact the word-line structure 300 overlapping the active region 100 that is spaced apart from the active region 100 in the second direction (Y). Some of the plurality of storage-node pad regions 530 may be arranged spaced apart from each other in the first direction (X). Some others of the plurality of storage-node pad regions 530 may be arranged spaced apart from each other in the second direction (Y).

Each of the plurality of storage-node contact regions 540 may include a conductive material. For example, each of the plurality of storage-node contact regions 540 may include at least one of polysilicon, aluminum, copper, and titanium. The polysilicon may include predetermined impurities for improving conductivity. Each of the storage-node contact regions 540 may be arranged between two adjacent bit lines. The storage-node contact regions 540 may overlap with the other end of the active region 100. Some of the storage-node contact regions 540 may overlap with the word-line structure 300 that overlaps the active region 100. Each of the plurality of storage-node contact regions 540 may be arranged spaced apart from each other in the first direction (X). Each of the plurality of storage-node contact regions 540 may be arranged spaced apart from each other in the second direction (Y).

FIG. 4 is a cross-sectional view illustrating a structure of the semiconductor device taken along the line A-A' of FIGS. 2 and 3 according to some embodiments of the present disclosure.

Referring to FIGS. 2, 3 and 4, a first cross-section (CS1) may include a substrate region 10, a main active region 110, a sub-active region 120, a cell isolation region 200, a word-line structure 300, a bit-line structure 400, a storage-node pad region 530, and a storage-node contact region 540.

The substrate region 10 may be a semiconductor region disposed below the main active region 110 and the sub-active region 120. The substrate region 10 may include a semiconductor material. For example, the substrate region 10 may include at least one of silicon, silicon germanium, or a combination thereof.

The main active region 110 may be disposed inside a semiconductor layer (SL). The main active region 110 may be spaced apart from a surface (e.g., a top surface) of the semiconductor layer (SL) by a predetermined distance. For example, the predetermined distance may be the same or substantially the same as a height of the bit-line pad region 430 or a height of the storage-node pad region 530, but may vary due to fabrication limitations or variables. The main active region 110 may contact the side and bottom surfaces of the word-line structure 300. For example, the main active region 110 may surround the side and bottom surfaces of the word-line insulation layer 340.

The sub-active region 120 may be a region that extends from the side surface of the main active region 110 by a predetermined thickness. One side surface of the sub-active region 120 may contact the cell isolation region 200.

The cell isolation region 200 may contact the side surface of the sub-active region 120. The cell isolation region 200 may contact the bit-line pad region 430 or the storage-node pad region 530.

The word-line structure 300 may include a first word-line electrode layer 310, a second word-line electrode layer 320, a word-line capping layer 330, and a word-line insulation layer 340. The word-line structure 300 may extend (or be recessed) into the interior of the semiconductor layer (SL) by a predetermined depth (hereinafter referred to as a first depth) in the third direction (Z) from the surface (50) of the semiconductor layer (SL). The word-line structure 300 may extend into the interior of the semiconductor layer (SL) by a predetermined depth from a central region of the main active region 110 (or the active region 100). In some embodiments, the surface (50) of the semiconductor layer (SL) may be defined as the same position as the top surface of the word-line structure 300.

The first word-line electrode layer 310 may include a conductive material, such as, for example, tungsten, aluminum, copper, tungsten nitride, tungsten silicide, cobalt silicide, titanium silicide, tantalum nitride, or a combination thereof. The first word-line electrode layer 310 may be disposed below the second word-line electrode layer 320. The side and bottom surfaces of the first word-line electrode layer 310 may be surrounded by a word-line insulation layer 340.

The second word-line electrode layer 320 may include a conductive material, such as, for example, tungsten, aluminum, copper, tungsten nitride, tungsten silicide, cobalt silicide, titanium silicide, tantalum nitride, or a combination thereof. The second word-line electrode layer 320 may form a region of the word-line structure into which predetermined impurities, such as, for example, phosphorus, germanium, and the like are implanted. The second word-line electrode layer 320 may be disposed on the first word-line electrode layer 310. The second word-line electrode layer 320 may be disposed on the top surface (also referred to as the upper or uppermost surface) of the first word-line electrode layer 310. The second word-line electrode layer 320 may be disposed below the word-line capping layer 330. Both side surfaces of the second word-line electrode layer 320 may contact the word-line insulation layer 340.

Although not shown in the drawings, a predetermined anti-oxidation layer may be arranged between the first word-line electrode layer 310 and the second word-line electrode layer 320. The predetermined anti-oxidation layer may capture (or collect) impurities (e.g., oxygen) contained in the first and second word-line electrode layers (310, 320).

Each of the first and second word-line electrode layers (310, 320) may receive a word-line signal as an input. When the word-line signal has a high level, a channel in which charges move may be formed around the word-line structure 300 within the main active region 110 and the sub-active region 120. When the word-line signal has a low level, the channel may not be formed. When the channel is formed, the bit-line electrode layer 410 and the storage-node contact region 540 may be electrically connected to each other. For example, in an operation of recording data "1", when a high-level bit-line signal is applied to the bit-line electrode layer 410 and a word-line signal is applied to the first and second word-line electrode layers (310, 320), charges may move to the storage-node contact region 540 according to the bit-line signal of the bit-line electrode layer 410 through the bit-line contact region 440, the bit-line pad region 430, the channel, and the storage-node pad region 530. Since the storage-node contact region 540 may be electrically connected to a predetermined capacitor structure (not shown), the charges may be stored in the capacitor structure through the storage-node contact region 540. The capacitor structure may be modeled in a circuit diagram as in the capacitor (CAP) of FIG. 1.

The word-line capping layer 330 may include an insulation material. For example, the word-line capping layer 330 may include silicon nitride, silicon oxide, silicon oxynitride, or a combination thereof. The word-line capping layer 330 may be disposed on the second word-line electrode layer 320. The word-line capping layer 330 may be disposed on the top surface (also referred to as upper or uppermost surface) of the second word-line electrode layer 320. Both side surfaces of the word-line capping layer 330 may contact the word-line insulation layer 340. The word-line capping layer 330 may be a region filled with an insulation material between a surface (50) of the semiconductor layer (SL) and a top surface of the second word-line electrode layer 320. The word-line capping layer 330 may electrically isolate the first and second word-line electrode layers (310, 320) from the bit-line structure 400. The word-line capping layer 330 may electrically isolate the first and second word-line electrode layers (310, 320) from the storage-node contact region 540. The depth of the word-line capping layer 330 from the surface (50) of the semiconductor layer (SL) may be shallower than the depth of the bit-line pad region 430 or the depth of the storage-node pad region 530 as shown in the drawings. However, other embodiments are also possible. For example, according to another embodiment (not shown), the depth of the word-line capping layer 330 may be formed deeper than the depth of the bit-line pad region 430 and the depth of the storage-node pad region 530.

The word-line insulation layer 340 may include an insulation material. For example, the word-line insulation layer 340 may include silicon oxide, hafnium oxide, hafnium silicon oxide, hafnium silicon oxynitride, or a combination thereof. The word-line insulation layer 340 may be formed conformally along the side and bottom surfaces of the word-line structure 300. The word-line insulation layer 340 may physically isolate the first and second word-line electrode layers (310, 320) from the main active region 110. The word-line insulation layer 340 may electrically isolate the first and second word-line electrode layers (310, 320) from the storage-node pad region 530.

The bit-line structure 400 may include a bit-line electrode layer 410, a bit-line spacer 420, a bit-line pad region 430, a bit-line contact region 440, and a bit-line capping layer 450.

The bit-line electrode layer 410 may include a conductive material. For example, the bit-line electrode layer 410 may include tungsten, aluminum, copper, tungsten nitride, tungsten silicide, cobalt silicide, titanium silicide, tantalum nitride, or a combination thereof. The bit-line electrode layer 410 may be arranged spaced apart from the surface (50) of the semiconductor layer (SL). The bit-line electrode layer 410 may be arranged spaced apart from the bit-line pad region 430. The bit-line electrode layer 410 may overlap with the bit-line pad region 430 when viewed in the third direction (Z). The bit-line electrode layer 410 may overlap with the word-line structure 300. Each of the two side surfaces of the bit-line electrode layer 410 may contact the bit-line spacer 420. The bit-line electrode layer 410 may be disposed below the bit-line capping layer 450.

The bit-line spacer 420 may include an insulation material. For example, the bit-line spacer 420 may include at least one of silicon oxide, silicon nitride, silicon oxynitride, or a combination thereof. The bit-line spacer 420 may contact both side surfaces of the bit-line electrode layer 410. The bit-line spacer 420 may contact both side surfaces of the bit-line contact region 440. The bit-line spacer 420 may contact and cover both side surfaces of the bit-line capping layer 450. The bit-line spacer 420 may electrically isolate the bit-line electrode layer 410 and the storage-node contact region 540 from each other. The bit-line spacer 420 may electrically isolate the bit-line contact region 440 and the storage-node contact region 540 from each other. The bit-line spacer 420 may wholly cover the side surfaces of the bit-line contact region 440, the bit-line electrode layer 410, and bit-line capping layer 450.

The bit-line pad region 430 may include a conductive material. For example, the bit-line pad region 430 may include polysilicon. The polysilicon may include predetermined impurities. The bit-line pad region 430 may be formed to be recessed from the surface (50) of the semiconductor layer (SL) by a predetermined depth (hereinafter referred to as a second depth). The bottom surface of the bit-line pad region 430 may contact each of the main active region 110 and the sub-active region 120. One side surface of the bit-line pad region 430 may contact the word-line structure 300. The second depth, which is the depth of the bit-line pad region 430, may be shallower than the first depth, which is the depth of the word-line structure 300.

In a situation where there is no bit-line pad region 430, when the word-line structure 300 is misaligned from the center of the active region 100 toward the bit-line contact region 440 (based on FIG. 4, when the word-line structure 300 is formed to be shifted (or biased) to the left), a contact area between the bit-line contact region 440 and the active region 100 may decrease in size, and there may occur various problems such as increased contact resistance, decreased current capacity, and performance degradation caused by increased temperature. However, when the bit-line pad region 430 is formed, the top surface of the bit-line pad region 430 may secure a contact area with the bit-line contact region 440, and the bottom surface of the bit-line pad region 430 may secure a contact area with the main active region 110 and the sub-active region 120, so that the contact resistance is reduced, the current capacity is increased, and the temperature increase is lowered, thereby improving performance of the semiconductor device 1.

The bit-line contact region 440 may include a conductive material. For example, the bit-line contact region 440 may include at least one of polysilicon, copper, aluminum, titanium, titanium nitride, or a combination thereof. The bit-line contact region 440 may be formed of the same material as the bit-line electrode layer 410 or may be formed of a different material from the bit-line electrode layer 410. When the bit-line contact region 440 and the bit-line electrode layer 410 are formed of different materials, it may be more advantageous, for example, to select for the bit-line electrode layer 410 a metal material having high conductivity. In contrast, it may be more advantageous to select for the bit-line contact region 440 a material that is advantageous for reducing contact resistance between the bit-line electrode layer 410 and the bit-line pad region 430. The bit-line contact region 440 may contact the bottom surface of the bit-line electrode layer 410. Each of the two side surfaces of the bit-line contact region 440 may contact the bit-line spacer 420. The bottom surface of the bit-line contact region 440 may contact the bit-line pad region 430. The bit-line contact region 440 may be disposed on the surface (50) of the semiconductor layer (SL).

The bit-line capping layer 450 may include an insulation material. For example, the bit-line capping layer 450 may include silicon oxide, silicon nitride, silicon oxynitride, or a combination thereof. The bit-line capping layer 450 may contact the top surface of the bit-line electrode layer 410. The bit-line capping layer 450 may contact the bit-line spacer 420. The bit-line capping layer 450 together with the bit-line spacer 420 may prevent both the bit-line electrode layer 410 and the bit-line contact region 420 from electrically interacting with components disposed around the bit-line structure 400.

The storage-node pad region 530 may include a conductive material. For example, the storage-node pad region 530 may include polysilicon. The polysilicon may include predetermined impurities. The storage-node pad region 530 may be formed to be recessed from the surface (50) of the semiconductor layer (SL) by a predetermined depth (hereinafter referred to as a third depth). The bottom surface of the storage-node pad region 530 may contact each of the main active region 110 and the sub-active region 120. One side surface of the storage-node pad region 530 may contact the word-line structure 300. The third depth, which is the depth of the storage-node pad region 530, may be shallower than the first depth, which is the depth of the word-line structure 300. The third depth, which is the depth of the storage-node pad region 530, may be the same or substantially the same as the second depth, which is the depth of the bit-line pad region 430.

In the absence of a storage-node pad region 530, misalignment of the word-line structure 300-particularly when shifted to the right from the center of the active region 100 toward the storage-node contact region 540 (as illustrated in FIG. 4)-can lead to a reduction in the contact area between the storage-node contact region 540 and the active region 100. This decreased contact area may result in several issues, including higher contact resistance, reduced current capacity, and performance degradation due to increased temperature.. However, in the presence of the storage-node pad region 530, the contact area may be increased. The increased contact area may result lower contact resistance, increased current capacity, and less performance degradation due to the increased temperature.

The storage-node contact region 540 may include a conductive material. For example, the storage-node contact region 540 may include at least one of polysilicon, copper, aluminum, titanium, titanium nitride, or a combination thereof. The bottom surface of the storage-node contact region 540 may contact the storage-node pad region 530. One side surface of the storage-node contact region 540 may contact the bit-line spacer 420. The storage-node contact region 540 may be disposed on the surface (50) of the semiconductor layer (SL).

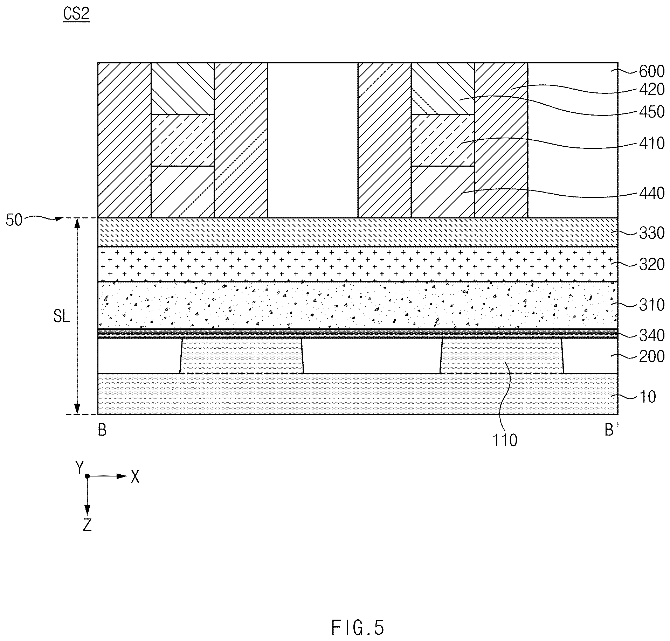

In the following description of FIGS. 5 to 18F, descriptions overlapping with those described in FIGS. 1 to 4 may be omitted to avoid obfuscating the present disclosure with repetitive description.

FIG. 5 is a cross-sectional view illustrating a structure of the semiconductor device taken along the line B-B' of FIGS. 2 and 3 according to some embodiments of the present disclosure.

Referring to FIGS. 2, 3, 4, and 5, the second cross-section (CS2) may include a substrate region 10, a main active region 110, a cell isolation region 200, a first word-line electrode layer 310, a second word-line electrode layer 320, a word-line capping layer 330, a word-line insulation layer 340, a bit-line electrode layer 410, a bit-line spacer 420, a bit-line contact region 440, a bit-line capping layer 450, and a contact insulation region 600.

The first word-line electrode layer 310 may extend in the first direction (X). The first word-line electrode layer 310 may be disposed on the word-line insulation layer 340. The second word-line electrode layer 320 may extend in the first direction (X). The second word-line electrode layer 320 may be disposed on the first word-line electrode layer 310. The word-line capping layer 330 may extend in the first direction (X). The word-line capping layer 330 may be disposed on the second word-line electrode layer 320. The word-line insulation layer 340 may extend in the first direction (X). The bottom surface of the word-line insulation layer 340 may contact each of the cell isolation region 200 and the main active region 110.

A plurality of bit-line electrode layers 410 may be arranged spaced apart from each other in the first direction (X). Both side surfaces of each of the plurality of bit-line electrode layers 410 may contact the bit-line spacers 420. The contact insulation region 600 may be disposed between the bit-line spacers 420 arranged on one side surfaces of the different bit-line electrode layers 410.

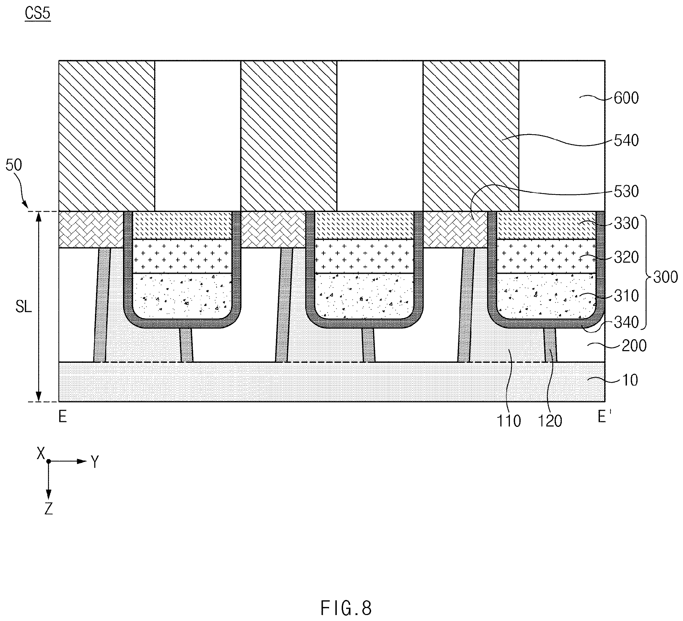

The contact insulation region 600 may include an insulation material. For example, the contact insulation region 600 may include at least one of silicon oxide, silicon nitride, silicon oxynitride, or a combination thereof. The contact insulation region 600 will be described in more detail later with reference to FIG. 8.

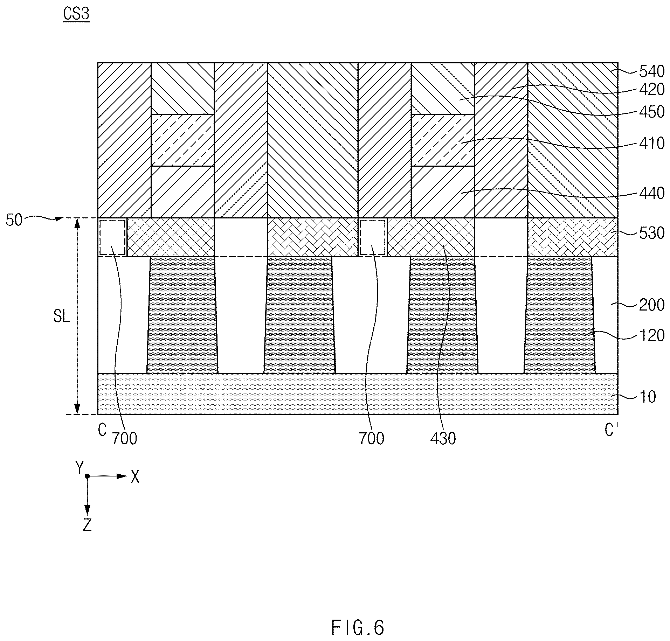

FIG. 6 is a cross-sectional view illustrating a structure of the semiconductor device taken along the line C-C' of FIGS. 2 and 3 according to some embodiments of the present disclosure.

Referring to FIGS. 2, 3, 4, and 6, the third cross-section (CS3) may include a substrate region 10, a sub-active region 120, a cell isolation structure 200, a bit-line electrode layer 410, a bit-line spacer 420, a bit-line pad region 430, a bit-line contact region 440, a bit-line capping layer 450, a storage-node pad region 530, a storage-node contact region 540, and a pad insulation region 700.

The bit-line pad region 430 may contact the top surface of the sub-active region 120. One side (e.g., the right side in FIG. 6) of the bit-line pad region 430 may contact the cell isolation region 200. The other side (e.g., the left side in FIG. 6) of the bit-line pad region 430 may contact the pad insulation region 700.

The storage-node pad region 530 may contact the top surface of the sub-active region 120. One side (e.g., the left side in FIG. 6) of the storage-node pad region 530 may contact the cell isolation region 200. The other side (e.g., the right side in FIG. 6) of the storage-node pad region 530 may contact the pad insulation region 700.

The plurality of bit-line pad regions 430 and the plurality of storage-node pad regions 530 may be alternately arranged in the first direction (X).

Each of the two side surfaces of the storage-node contact region 540 may contact the bit-line spacer 420.

Each of the plurality of bit-line contact regions 440 may contact the top surface of a corresponding one of the bit-line pad regions 430. On the other hand, each of the plurality of storage-node contact regions 540 may contact the top surface of a corresponding one of the storage-node pad regions 530.

The pad insulation region 700 may include an insulation material, such as, for example, at least one of silicon oxide, silicon nitride, silicon oxynitride, or a combination thereof. Each of the pad insulation regions 700 may be disposed between a corresponding pair of a bit-line contact region 430 and a storage-node contact region 530 adjacent to the bit-line contact region 430. The pad insulation region 700 and the cell isolation region 200 may be alternately arranged in the space between the bit-line contact region 430 and the storage-node contact region 530 adjacent to each other, but the embodiments of the present disclosure are not limited thereto, and may vary depending on fabrication method.

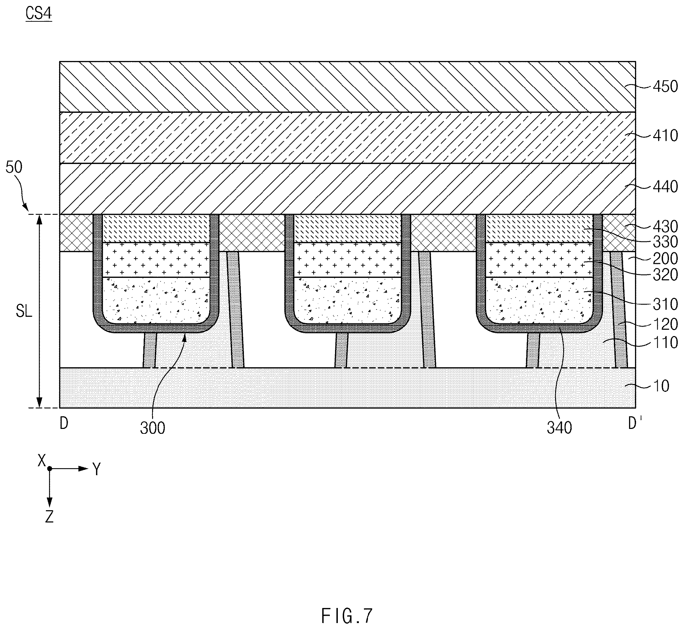

FIG. 7 is a cross-sectional view illustrating a structure of the semiconductor device taken along the line D-D' of FIGS. 2 and 3 according to some embodiments of the present disclosure.

Referring to FIGS. 2, 3, 4, and 7, the fourth cross-section (CS4) may include a substrate region 10, a main active region 110, a sub-active region 120, a cell isolation structure 200, a bit-line pad region 430, a first word-line electrode layer 310, a second word-line electrode layer 320, a word-line capping layer 330, a word-line insulation layer 340, a bit-line electrode layer 410, a bit-line contact region 440, and a bit-line capping layer 450.

The bit-line electrode layer 410 may extend in the second direction (Y). The bit-line contact region 440 may extend in the second direction (Y). The bit-line capping layer 450 may extend in the second direction (Y).

Some parts of the bottom surface of the word-line structure 300 may contact the main active region 110 or the sub-active region 120. Some other parts of the bottom surface of the word-line structure 300 may contact the cell isolation region 200. Also, one side of the word-line structure 300 may contact the main active region 110, while the other side of the word-line structure 300 may contact the cell isolation region 200. The regions of the word-line structure 300 where the bottom surface transitions into the side surfaces may have a curvature as illustrated in FIG. 7.

Each of the plurality of bit-line pad regions 430 may be disposed between adjacent word-line structures 300.

FIG. 8 is a cross-sectional view illustrating a structure of the semiconductor device taken along the line E-E' of FIGS. 2 and 3 according to some embodiments of the present disclosure.

Referring to FIGS. 2, 3, 4, and 8, the fifth cross-section (CS5) may include a substrate region 10, a main active region 110, a sub-active region 120, a cell isolation structure 200, a word-line structure 300, a storage-node pad region 530, a storage-node contact region 540, and a contact insulation region 600.

Both side surfaces of each of the plurality of storage-node contact regions 540 may contact the contact insulation regions 600. Both side surfaces of each of the plurality of contact insulation regions 600 may contact the storage-node contact region 540. The plurality of storage-node contact regions 540 and the plurality of contact insulation regions 600 may be alternately and repeatedly arranged in the second direction (Y).

The main active region 110 may contact a portion of the bottom surface of the word-line structure 300 and one side surface (e.g., the left side in FIG. 8) of the word-line structure 300. The storage-node pad region 530 may contact the one side surface (e.g., the left side in FIG. 8) of the word-line structure 300.

The cell isolation region 200 may contact a portion of the bottom surface of the word-line structure 300 and the other side surface (e.g., the right side as shown in FIG. 8) of the word-line structure 300. The cell isolation region 200 may contact the other side surface (e.g., the right side in FIG. 8) of the word-line structure 300.

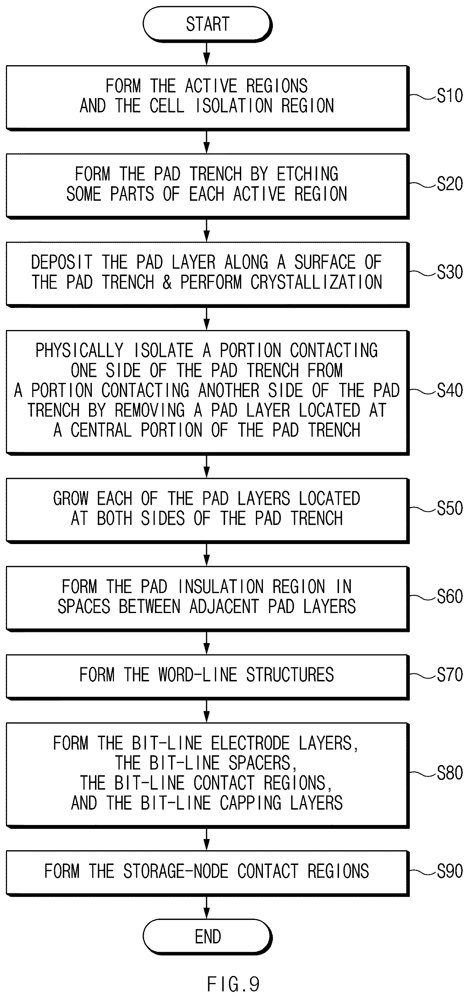

FIG. 9 is a flowchart illustrating a method for manufacturing the semiconductor device 1 according to some embodiments of the present disclosure.

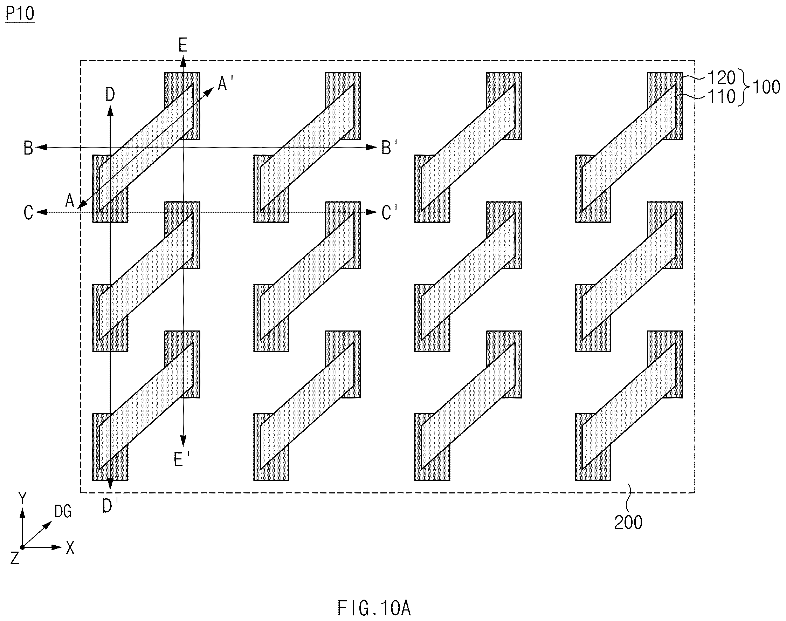

Referring to FIGS. 2, 3, and 9, a method for manufacturing the semiconductor device 1 may include forming (S10) a plurality of active regions 100 and a cell isolation region 200 surrounding the plurality of active regions 100. The method may include forming (S20) a pad trench by etching a portion of each of the plurality of active regions 100. The method may include depositing (S30) a pad layer along a surface of the pad trench and performing (S30) crystallization. The method may include physically isolating (S40) a pad layer contacting one side of the pad trench from a pad layer contacting the other side of the pad trench by removing a pad layer located at a central portion of the pad trench from among the pad layers. The method may include growing (S50) pad layers respectively contacting both sides of the pad trench. Operations S40 and S50 may be referred to collectively as an operation of forming the plurality of pad regions. The method may further include forming (S60) a pad insulation region between adjacent pad layers. The method may further include forming (S70) a plurality of word-line structures. The method may further include forming (S80) a plurality of bit-line electrode layers 410, a plurality of bit-line spacers 420, a plurality of bit-line contact regions 440 (see FIG. 10A and below), and a plurality of bit-line capping layers 450 (see FIG. 10A and below). The method may further include forming (S90) a plurality of storage-node contact regions 540.

Each of the operations S10 to S90 will be described in more detail with reference to FIGS. 10A to 18F.

FIG. 10A is a plan view illustrating a result of performing operation S10 of FIG. 9 according to some embodiments of the present disclosure.

Referring to FIGS. 9 and 10A, a plurality of main active regions 110 may be formed. Some parts of the plurality of main active regions 110 may be repeatedly formed spaced apart from each other in the first direction (X). Some other parts of the plurality of main active regions 110 may be repeatedly formed spaced apart from each other in the second direction (Y). Each of the plurality of main active regions 110 may be formed in a shape extending in a diagonal direction (DG) that forms an acute angle with each of the first direction (X) and the second direction (Y).

Thereafter, a plurality of sub-active regions 120 may be formed from both ends of each of the plurality of main active regions 110. Each of the plurality of sub-active regions 120 may be formed, for example, by epitaxial growth. The epitaxial growth may include, for example, a chemical vapor deposition (CVD), or a molecular beam epitaxy (MBE), or a combination thereof.

Afterwards, a cell isolation region 200 may be formed to gap-fill the remaining empty spaces except for the plurality of main active regions 110 and the plurality of sub-active regions 120 with an insulation material, such as, for example, silicon oxide, silicon nitride, silicon oxynitride, and the like.

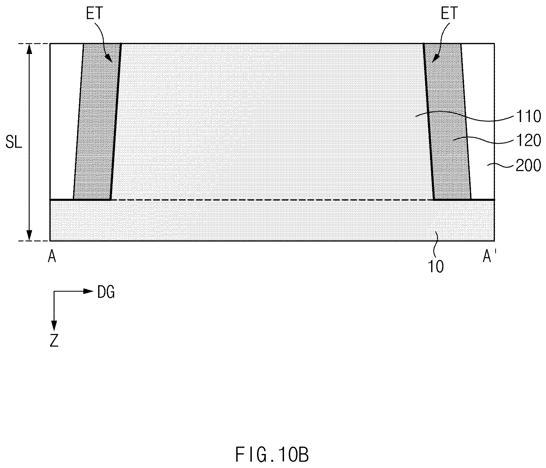

FIG. 10B is a cross-sectional view illustrating a structure of the semiconductor device taken along the line A-A' of FIG. 10A according to some embodiments of the present disclosure.

Referring to FIGS. 9, 10A, and 10B, an etching trench (ET) for forming the main active region 110 may be formed. The semiconductor material of the main active region 110 may grow from the inner wall of the etching trench (ET) to form the sub-active region 120.

In the present embodiment, each of the plurality of main active regions 110 may be defined as a region having the same depth as the etching trench (ET). In the present disclosure, the substrate region 10 may contact the bottom surface of the plurality of main active regions 110, and may be defined as the remaining regions except for the main active regions 110 after the etching trench (ET) is formed in the predetermined semiconductor substrate.

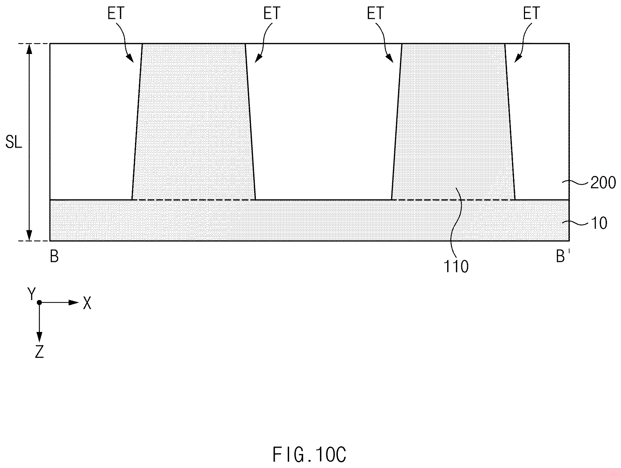

FIG. 10C is a cross-sectional view illustrating a structure of the semiconductor device taken along the line B-B' of FIG. 10A according to some embodiments of the present disclosure.

Referring to FIGS. 9, 10A, and 10C, epitaxial growth may not occur in the vicinity of the plurality of main active regions 110, so that the sub-active regions 120 may not be formed in the vicinity of the central portions of the main active regions 110, but the embodiments of the present disclosure are not limited thereto, and this embodiment may vary depending on fabrication variables and limitations. The plurality of main active regions 110 may be repeatedly formed in the first direction (X).

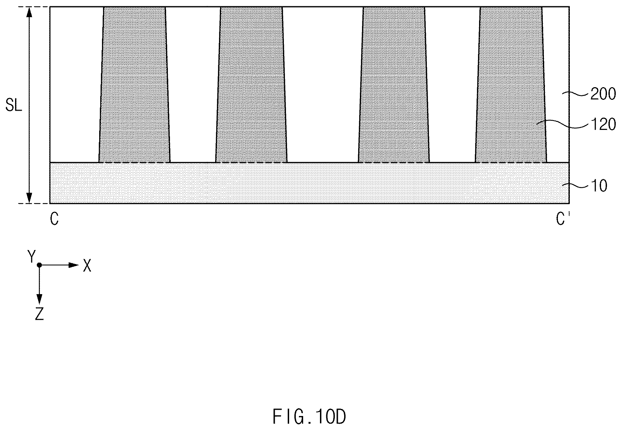

FIG. 10D is a cross-sectional view illustrating a structure of the semiconductor device taken along the line C-C' of FIG. 10A according to some embodiments of the present disclosure.

Referring to FIGS. 9, 10A, and 10D, the cell isolation region 200 may be formed to contact the side surfaces of the plurality of sub-active regions 120. The plurality of sub-active regions 120 may be repeatedly formed in the first direction (X).

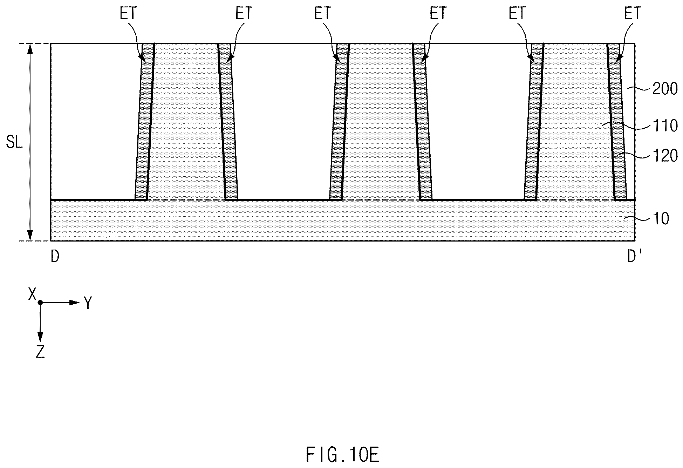

FIG. 10E is a cross-sectional view illustrating a structure of the semiconductor device taken along the line D-D' of FIG. 10A according to some embodiments of the present disclosure.

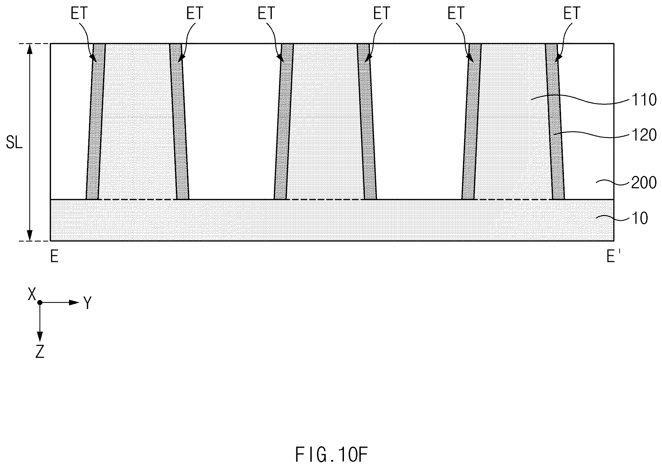

FIG. 10F is a cross-sectional view illustrating a structure of the semiconductor device taken along the line E-E' of FIG. 10A according to some embodiments of the present disclosure.

Referring to FIGS. 9, 10A, 10E, and 10F, a plurality of main active regions 110 may be repeatedly formed in the second direction (Y). Each of the plurality of sub-active regions 120 may be formed through epitaxial growth from the side surfaces of the main active regions 110.

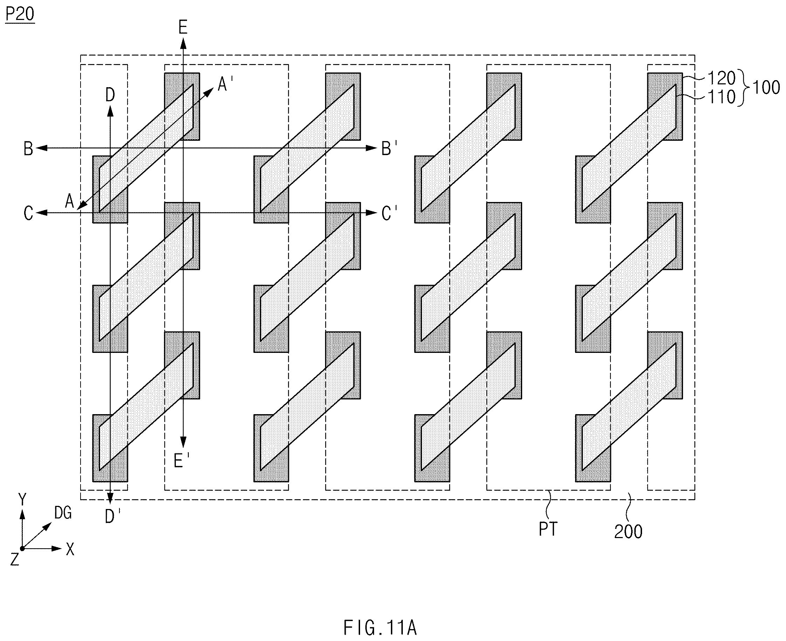

The following embodiments of FIGS. 11A to 11F will hereinafter be described with a focus on the characteristics that are different from those of FIGS. 10A to 10F.

FIG. 11A is a plan view illustrating a result of performing operation S20 of FIG. 9 according to some embodiments of the present disclosure.

Referring to FIGS. 9, 10A, and 11A, a pad trench (PT) may be formed over a portion of each of two adjacent active regions 100. Each of the plurality of pad trenches (PTs) may be repeatedly formed spaced apart from each other in the first direction (X). Each of the plurality of pad trenches (PTs) may be formed to extend in the second direction (Y).

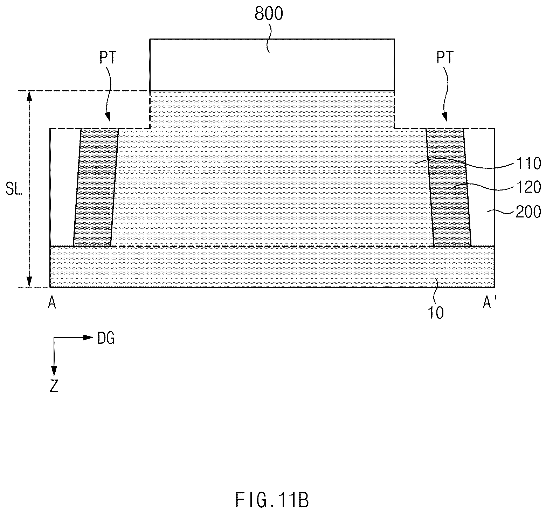

FIG. 11B is a cross-sectional view illustrating a structure of the semiconductor device taken along the line A-A' of FIG. 11A according to some embodiments of the present disclosure.

Referring to FIGS. 9, 10A, 11A, and 11B, an etch stop layer 800 may be formed at a position where the plurality of pad trenches (PTs) will not be formed. Thereafter, pad trenches (PTs) formed by etching the semiconductor layer (SL) to a predetermined depth may be formed at a position where the etch stop layer 800 is not formed. Each pad trench (PT) may be a trench formed by etching some parts of one end of the active region 100. This process ensures precise shaping of pad trenches (PTs) without affecting regions covered by the etch stop layer. By restricting the trench formation to areas without the etch stop layer, the design maintains structural integrity and functionality of the active region. The depth of the pad trenches may be carefully controlled to achieve optimal electrical and material properties.

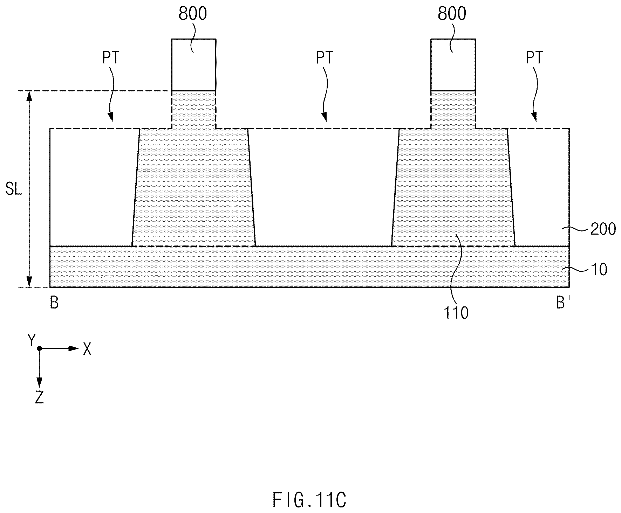

FIG. 11C is a cross-sectional view illustrating a structure of the semiconductor device taken along the line B-B' of FIG. 11A according to some embodiments of the present disclosure.

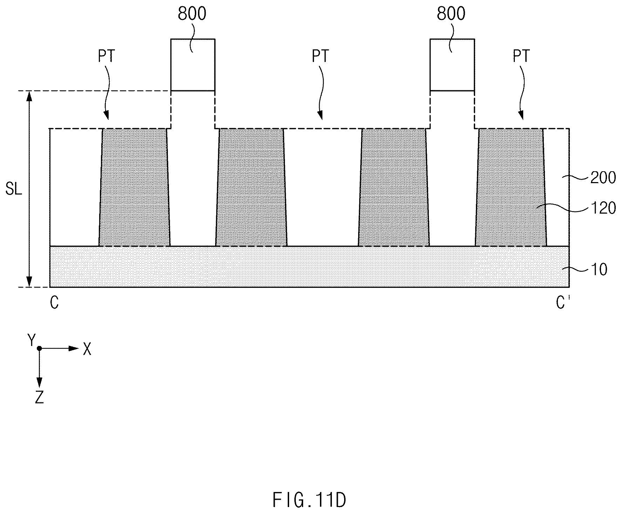

FIG. 11D is a cross-sectional view illustrating a structure of the semiconductor device taken along the line C-C' of FIG. 11A according to some embodiments of the present disclosure.

Referring to FIGS. 9, 10A, 11A, 11C, and 11D, the pad trench (PT) may be formed by etching some parts of one side (e.g., the right side in FIG. 11C) of one active region 100. Likewise, the pad trench (PT) may be formed by etching some parts of one side (e.g., the left side in FIG. 11C) of another active region 100 spaced apart from the one active region 100 in the first direction (X). The etch-stop layer 800 may be formed to extend in the second direction (Y).

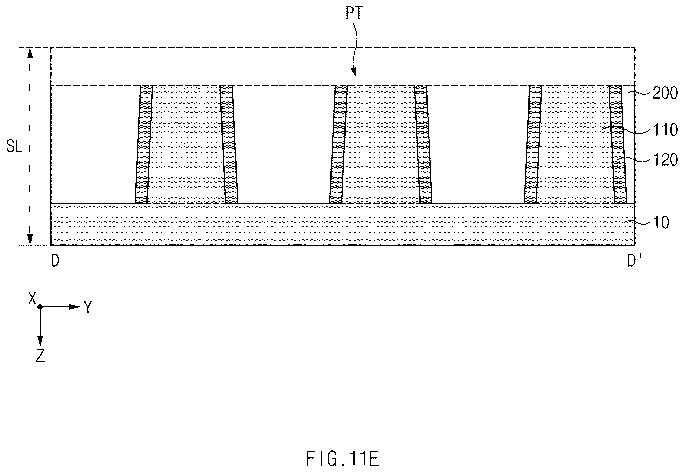

FIG. 11E is a cross-sectional view illustrating a structure of the semiconductor device taken along the line D-D' of FIG. 11A according to some embodiments of the present disclosure.

Referring to FIGS. 9, 10A, 11A, and 11E, the pad trench (PT) may be formed to extend in the second direction (Y). The depth of the pad trench (PT) etched from the surface of the semiconductor layer (SL) may be the same or substantially the same as the depth of the bit-line pad region 430 of FIG. 3.

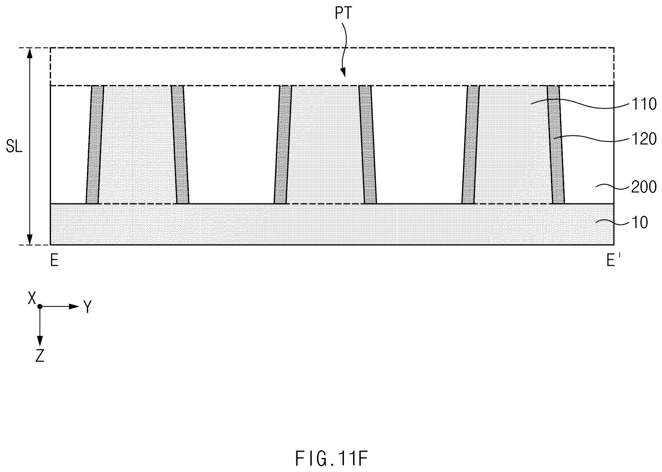

FIG. 11F is a cross-sectional view illustrating a structure of the semiconductor device taken along the line E-E' of FIG. 11A according to some embodiments of the present disclosure.

Referring to FIGS. 9, 10A, 11A, and 11F, the pad trench (PT) may be formed to extend in the second direction (Y). The depth of the pad trench (PT) etched from the surface of the semiconductor layer (SL) may be the same or substantially the same as the depth of the storage-node pad region 530 of FIG. 3.

The depth by which each of the pad trenches (PT) is recessed in the third direction (Z) may be shallower than the depth of the word-line structures 300 of FIG. 4.

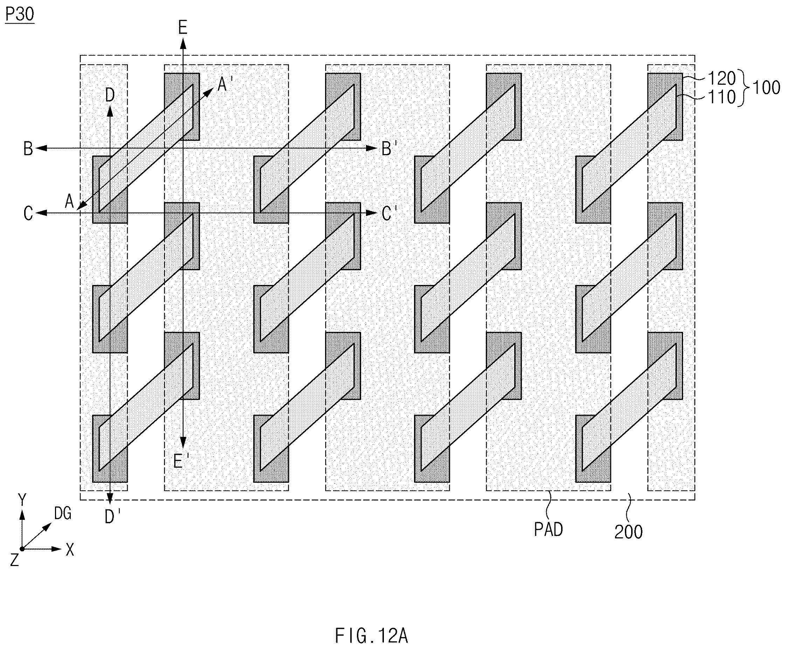

The following embodiments of FIGS. 12A to 12F will hereinafter be described with a focus on the characteristics that are different from those of FIGS. 11A to 11F.

FIG. 12A is a plan view illustrating a result of performing operation S30 of FIG. 9 according to some embodiments of the present disclosure.

Referring to FIGS. 9, 11A, and 12A, a pad layer (PAD) may be deposited and crystallized in the pad trench (PT).

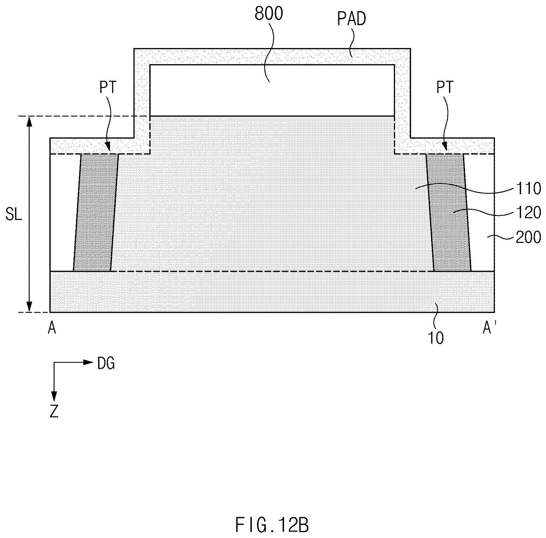

FIG. 12B is a cross-sectional view illustrating a structure of the semiconductor device taken along the line A-A' of FIG. 12A according to some embodiments of the present disclosure.

Referring to FIGS. 9, 11A, 12A, and 12B, the pad layer (PAD) may be formed to contact the bottom surface and the side surface of each of the plurality of pad trenches (PT). The pad layer (PAD) may be formed to cover the side and top surfaces of the etch stop layer 800. The pad layer (PAD) may be formed of, for example, polysilicon.

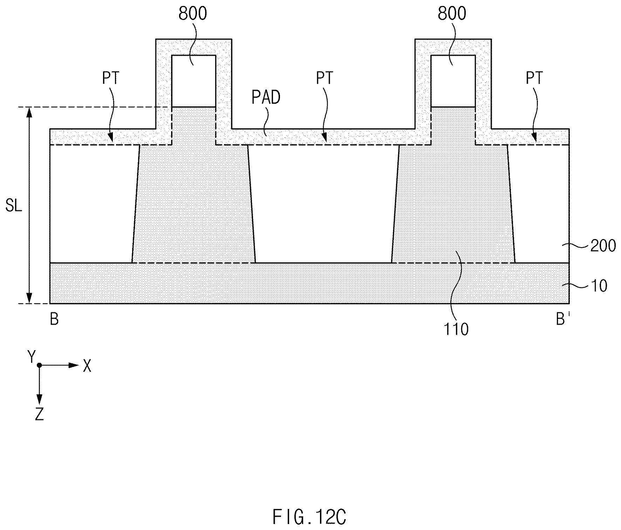

FIG. 12C is a cross-sectional view illustrating a structure of the semiconductor device taken along the line B-B' of FIG. 12A according to some embodiments of the present disclosure.

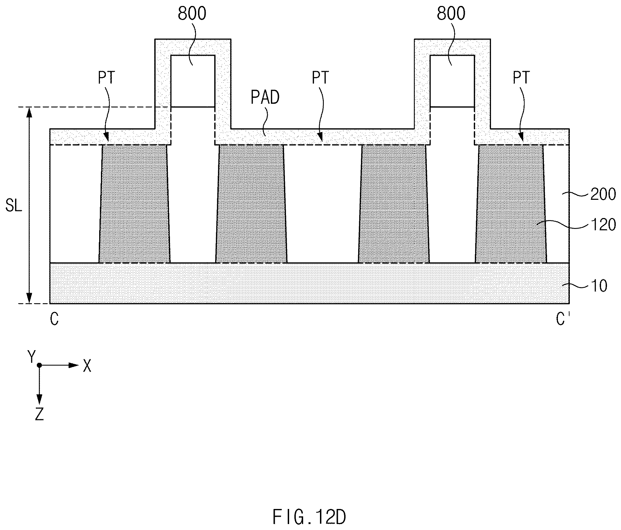

FIG. 12D is a cross-sectional view illustrating a structure of the semiconductor device taken along the line C-C' of FIG. 12A according to some embodiments of the present disclosure.

Referring to FIGS. 9, 11A, 12A, 12C, and 12D, the pad layer (PAD) may extend in the first direction (X). Since the pad trench (PT) is formed across a portion of each of the two active regions 100 adjacent to each other in the first direction (X), the pad trench (PT) may be formed to have a relatively large width in the first direction (X), and when considering a minimum pitch at which the etching process is possible, a process burden of the pad trench (PT) can be reduced. The relatively large width of the pad trench (PT) in the first direction (X) contributes to enhanced process efficiency by mitigating constraints imposed by fine-pitch etching limitations.

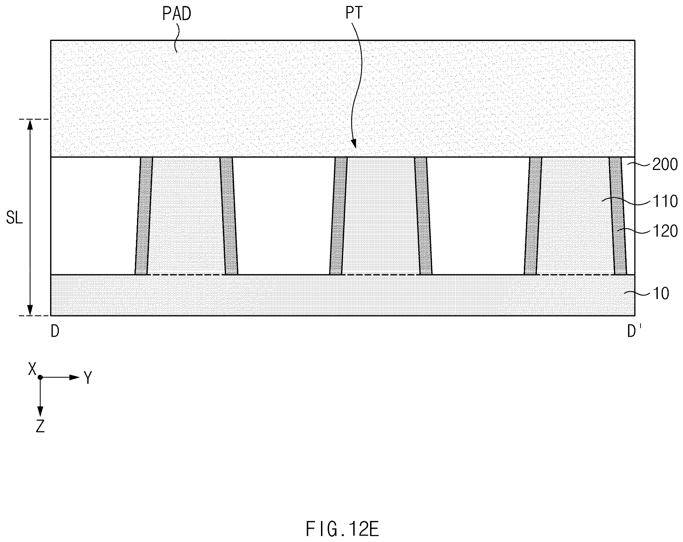

FIG. 12E is a cross-sectional view illustrating a structure of the semiconductor device taken along the line D-D' of FIG. 12A according to some embodiments of the present disclosure.

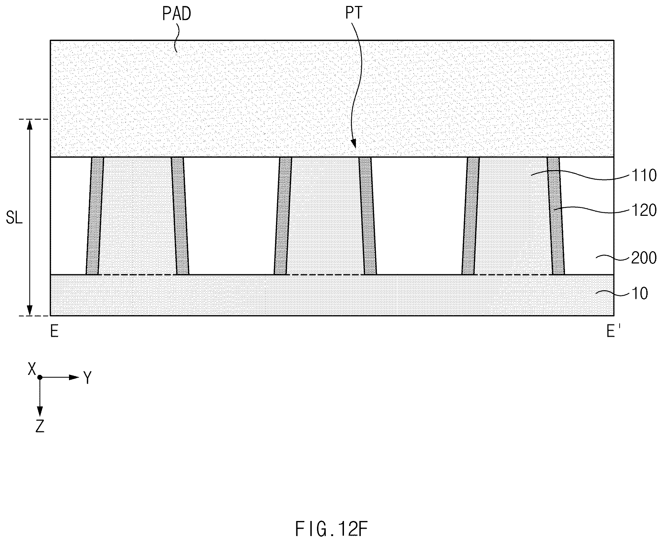

FIG. 12F is a cross-sectional view illustrating a structure of the semiconductor device taken along the line E-E' of FIG. 12A according to some embodiments of the present disclosure.

Referring to FIGS. 9, 11A, 12A, 12E, and 12F, the pad layer (PAD) may extend in the second direction (Y).

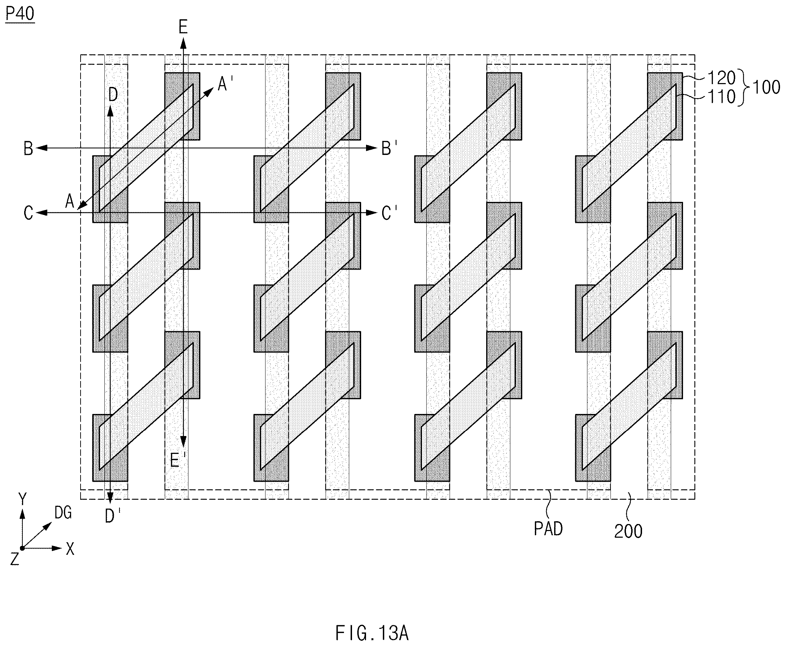

The following embodiments of FIGS. 13A to 13F will hereinafter be described with a focus on the characteristics that are different from those of FIGS. 12A to 12F.

FIG. 13A is a plan view illustrating a result of performing operation S40 of FIG. 9 according to some embodiments of the present disclosure.

Referring to FIGS. 9, 12A, and 13A, the pad layer (PAD) at the center of each of the plurality of pad trenches (PTs) is removed, so that a portion contacting one side of each pad trench (PT) and a portion contacting the other side of each pad trench (PT) can be physically isolated from each other. The pad layer at the center of each of the plurality of pad trenches (PTs) may be removed, and the remaining pad layer (PAD) may overlap with the end of each active region 100. The region from which the pad layer (PAD) is removed may extend in the second direction (Y).

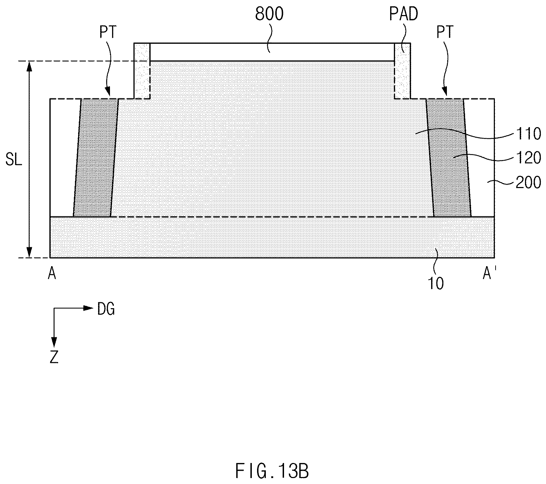

FIG. 13B is a cross-sectional view illustrating a structure of the semiconductor device taken along the line A-A' of FIG. 13A according to some embodiments of the present disclosure.

Referring to FIGS. 9, 12A, 13A, and 13B, the pad layer (PAD) may remain on one side of the active region 100. A pad layer (PAD) may also remain on the other side spaced apart from the one side of the active region 100 in the diagonal direction (DG).

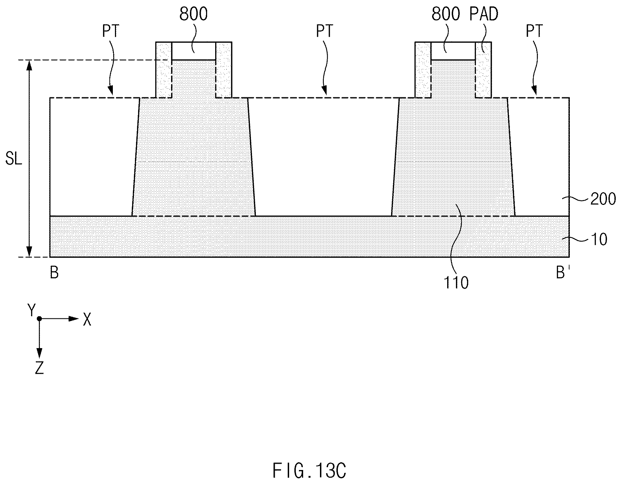

FIG. 13C is a cross-sectional view illustrating a structure of the semiconductor device taken along the line B-B' of FIG. 13A according to some embodiments of the present disclosure.

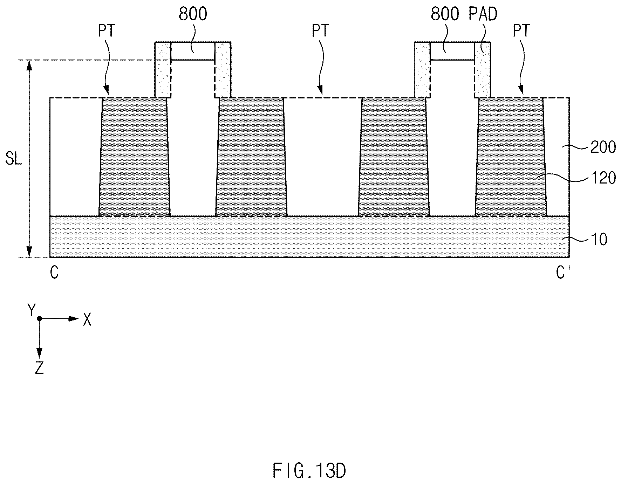

FIG. 13D is a cross-sectional view illustrating a structure of the semiconductor device taken along the line C-C' of FIG. 13A according to some embodiments of the present disclosure.

Referring to FIGS. 9, 12A, 13A, 13C, and 13D, a pad layer (PAD) contacting one side of the pad trench (PT) and a pad layer (PAD) contacting the other side of the pad trench (PT) may be spaced apart from each other in the first direction (X).

The active region 100 contacting the pad layer (PAD) on one side of the pad trench (PT) may be different from the active region 100 contacting the pad layer (PAD) on the other side of the pad trench (PT). To prevent electrical interaction between the spaced-apart active regions 100, the pad layer (PAD) on one side of the pad trench (PT) and the pad layer (PAD) on the other side must be spaced apart from each other. This separation may ensure electrical isolation between adjacent active regions.

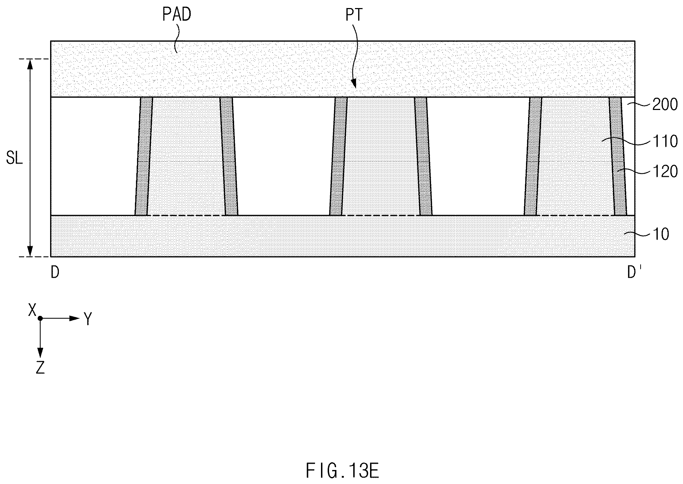

FIG. 13E is a cross-sectional view illustrating a structure of the semiconductor device taken along the line D-D' of FIG. 13A according to some embodiments of the present disclosure.

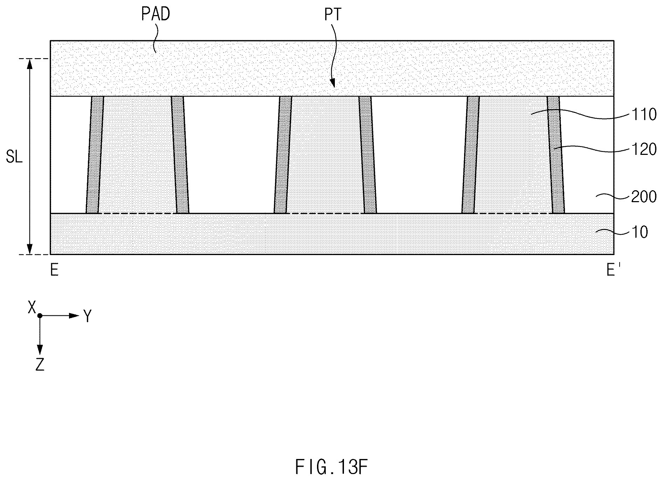

FIG. 13F is a cross-sectional view illustrating a structure of the semiconductor device taken along the line E-E' of FIG. 13A according to some embodiments of the present disclosure.

The cross-section of FIG. 13E may be the same or substantially the same as the cross-section of FIG. 12E. The cross-section of FIG. 13F may be the same or substantially the same as the cross-section of FIG. 12F.

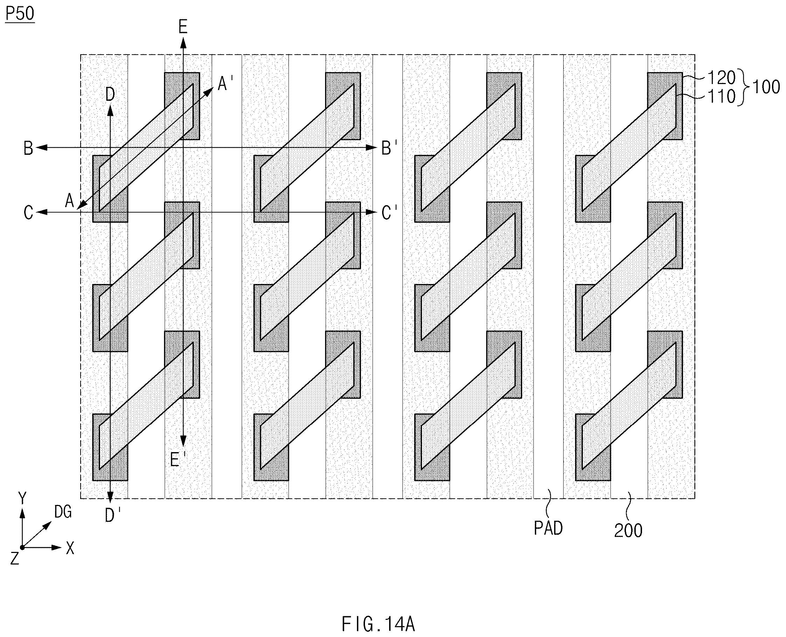

The following embodiments of FIGS. 14A to 14F will hereinafter be described with a focus on the characteristics that are different from those of FIGS. 13A to 13F.

FIG. 14A is a plan view illustrating a result of performing operation S50 of FIG. 9 according to some embodiments of the present disclosure.

Referring to FIGS. 9, 13A, and 14A, each of the pad layers (PADs) contacting each of the two sides of the plurality of pad trenches (PT) may grow increasing in width in the first direction (X).

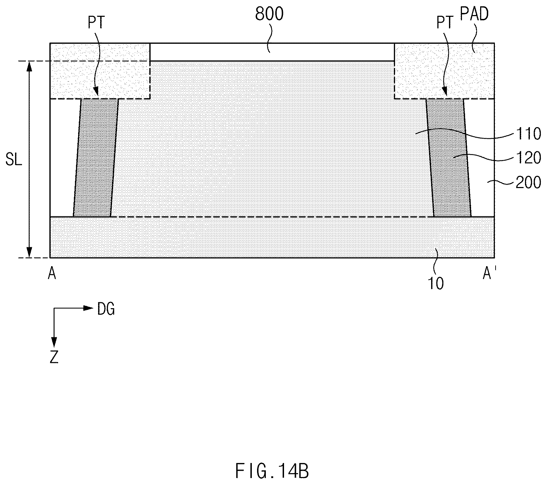

FIG. 14B is a cross-sectional view illustrating a structure of the semiconductor device taken along the line A-A' of FIG. 14A according to some embodiments of the present disclosure.

Referring to FIGS. 9, 13A, 14A, and 14B, the width of each pad layer (PAD) contacting each of the two sides of the plurality of pad trenches (PT) may increase. For example, the width of the pad layer (PAD) may increase to cover one end of the active region 100 (i.e., a portion of the active region 100 etched by the pad trench PT).

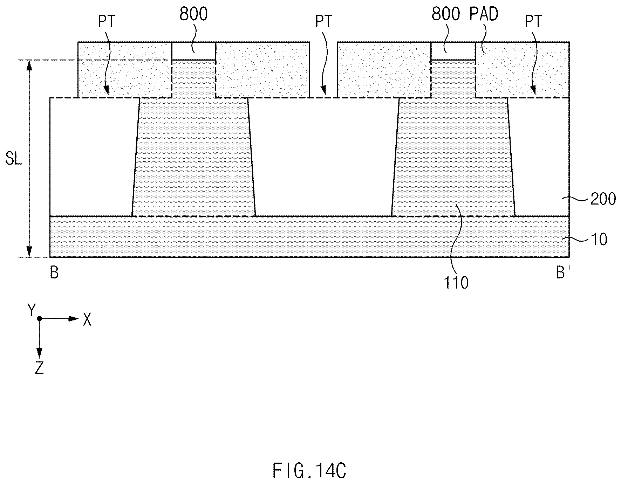

FIG. 14C is a cross-sectional view illustrating a structure of the semiconductor device taken along the line B-B' of FIG. 14A according to some embodiments of the present disclosure.

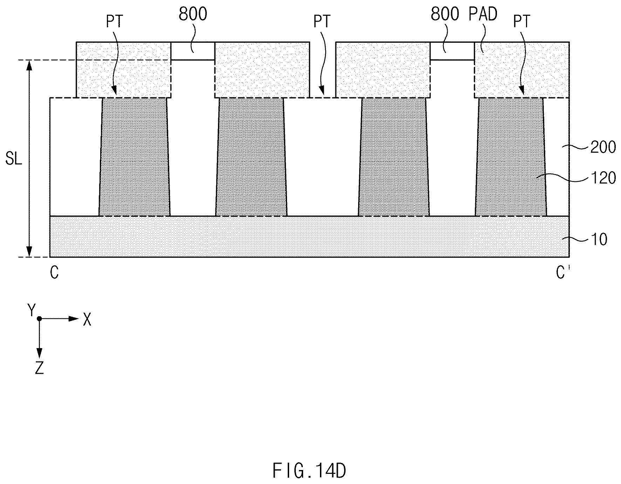

FIG. 14D is a cross-sectional view illustrating a structure of the semiconductor device taken along the line C-C' of FIG. 14A according to some embodiments of the present disclosure.

Referring to FIGS. 9, 13A, 14A, 14C and 14D, the width of each pad layer contacting both sides of each of the plurality of pad trenches (PTs) may increase. For example, the width of the pad layer (PAD) may be increased to cover one end of the active region 100 (i.e., a portion of the active region 100 etched by the pad trench PT).

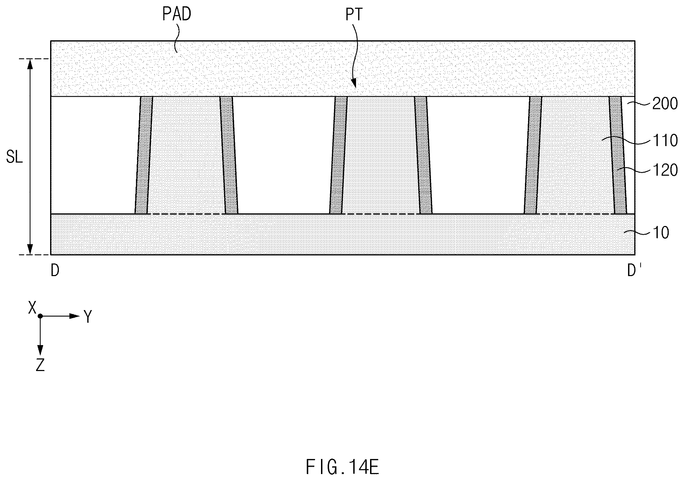

FIG. 14E is a cross-sectional view illustrating a structure of the semiconductor device taken along the line D-D' of FIG. 14A according to some embodiments of the present disclosure.

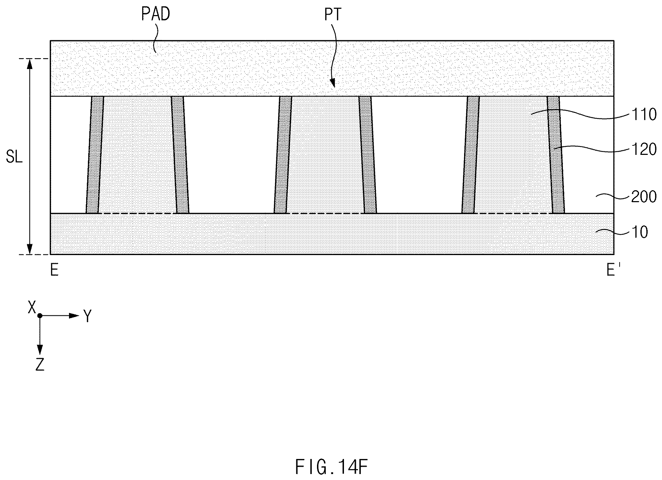

FIG. 14F is a cross-sectional view illustrating a structure of the semiconductor device taken along the line E-E' of FIG. 14A according to some embodiments of the present disclosure.

The cross-section of FIG. 14E may be the same or substantially the same as the cross-section of FIG. 13E. The cross-section of FIG. 14F may be the same or substantially the same as the cross-section of FIG. 13F.

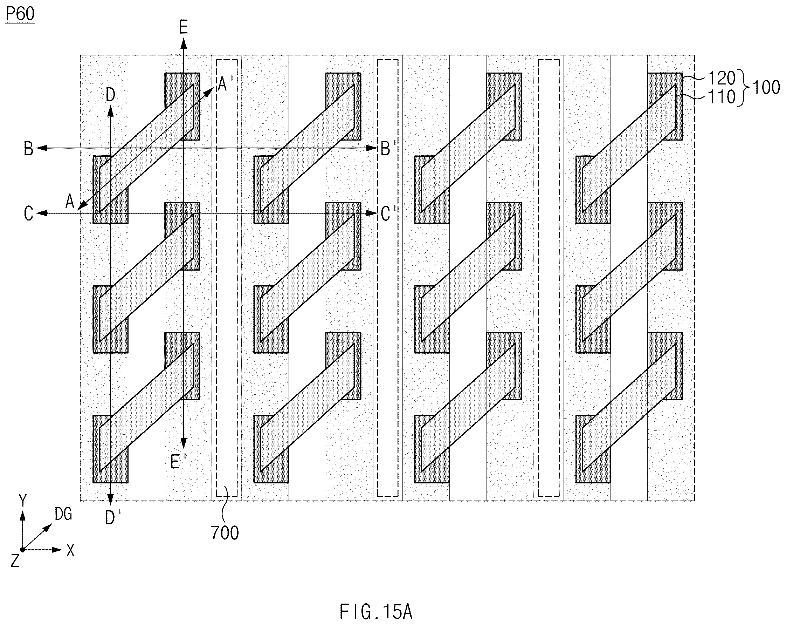

The following embodiments of FIGS. 15A to 15F will hereinafter be described with a focus on the characteristics that are different from those of FIGS. 14A to 14F.

FIG. 15A is a plan view illustrating a result of performing operation S60 of FIG. 9 according to some embodiments of the present disclosure.

Referring to FIGS. 9, 10A, and 15A, a pad insulation region 700 may be formed in a space between adjacent pad layers (PADs).

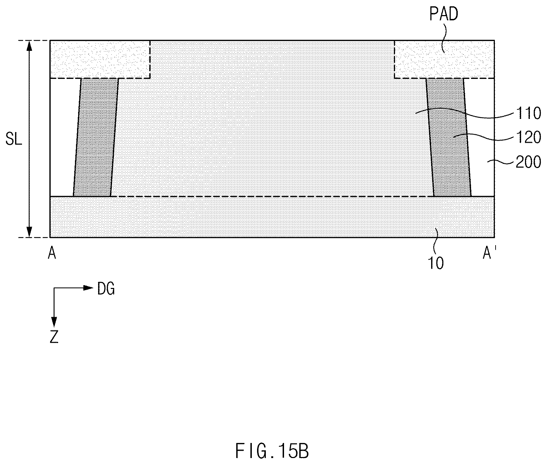

FIG. 15B is a cross-sectional view illustrating a structure of the semiconductor device taken along the line A-A' of FIG. 15A according to some embodiments of the present disclosure.

Referring to FIGS. 9, 10A, 15A, and 15B, the etch stop layer 800 may be removed and a planarization process may be performed thereon. The planarization process may be performed before forming the pad insulation region 700. In addition, the planarization process may include planarizing the surface of the semiconductor layer (SL).

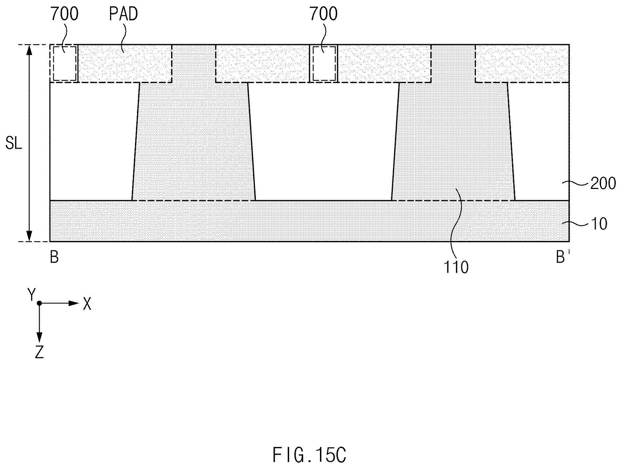

FIG. 15C is a cross-sectional view illustrating a structure of the semiconductor device taken along the line B-B' of FIG. 15A according to some embodiments of the present disclosure.

Referring to FIGS. 9, 10A, 15A, and 15C, the pad insulation region 700 may be arranged between adjacent pad layers (PADs).

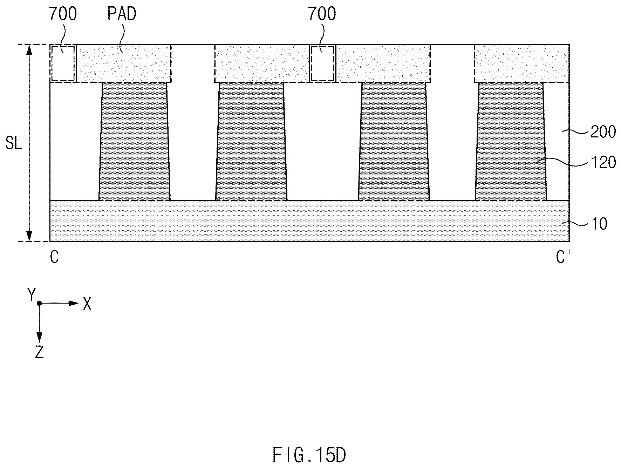

FIG. 15D is a cross-sectional view illustrating a structure of the semiconductor device taken along the line C-C' of FIG. 15A according to some embodiments of the present disclosure.

Referring to FIGS. 9, 10A, 15A, and 15D, the pad insulation regions 700 and the cell isolation regions 200 may be alternately arranged and filled in spaces between pad layers (PADs) that are repeatedly spaced apart from each other in the first direction (X).

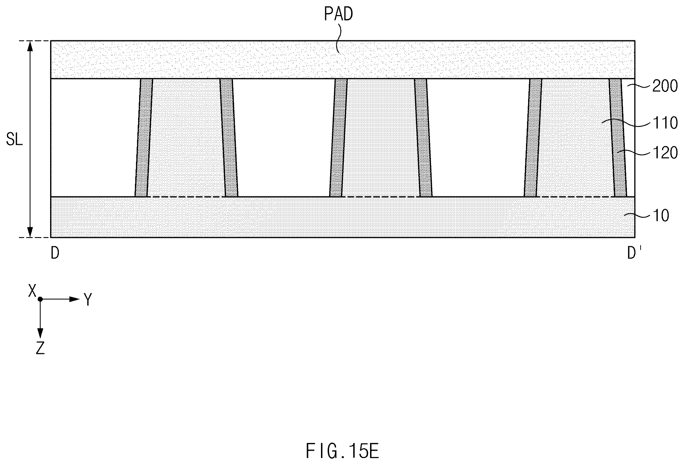

FIG. 15E is a cross-sectional view illustrating a structure of the semiconductor device taken along the line D-D' of FIG. 15A according to some embodiments of the present disclosure.

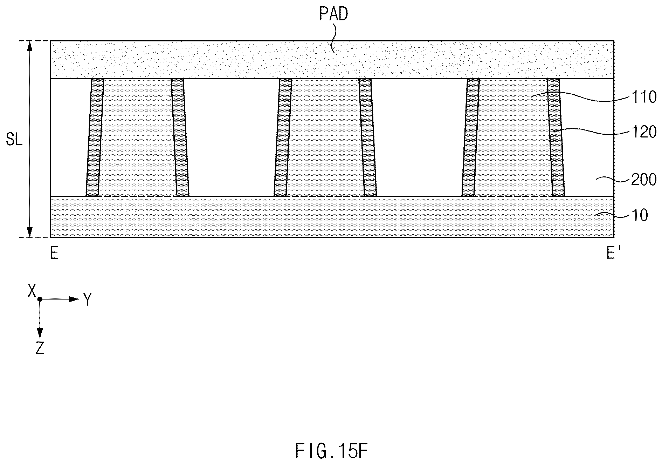

FIG. 15F is a cross-sectional view illustrating a structure of the semiconductor device taken along the line E-E' of FIG. 15A according to some embodiments of the present disclosure.

Referring to FIGS. 9, 10A, 15A, 15E, and 15F, as the process of planarizing the surface of the semiconductor layer (SL) progresses, the top surface of the pad layer (PAD) may coincide with the surface of the semiconductor layer (SL).

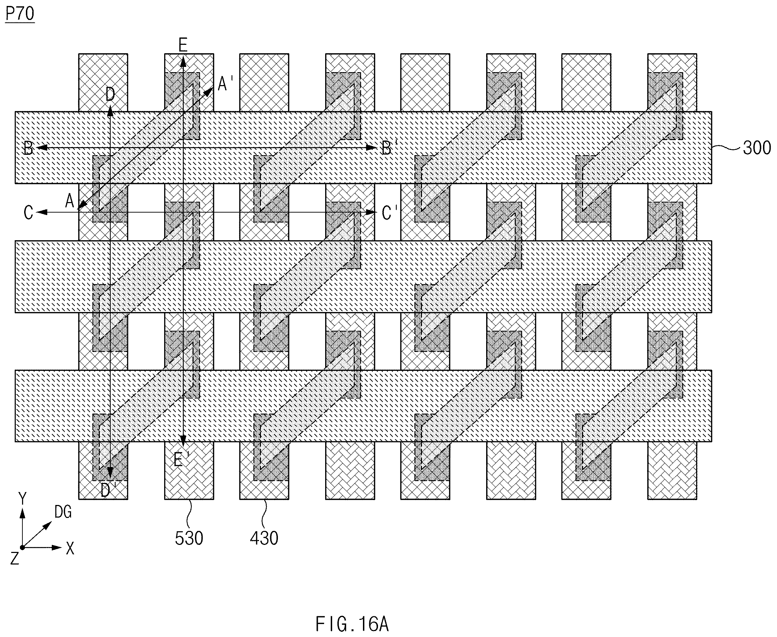

The following embodiments of FIGS. 16A to 16F will hereinafter be described with a focus on the characteristics that are different from those of FIGS. 15A to 15F.

FIG. 16A is a plan view illustrating a result of performing operation S70 of FIG. 9 according to some embodiments of the present disclosure.

Referring to FIGS. 9, 10A, and 16A, the word-line structure 300 may be formed to extend in the first direction (X). The word-line structure 300 may be formed to penetrate the pad layers (PAD). The word-line structure 300 may cut off (or sever) a portion of the pad layers (PAD). A portion of the cut and remaining pad layer (PAD) may become a bit-line pad layer 430, and another portion of the cut and remaining pad layer (PAD) may become a storage-node pad layer 530.

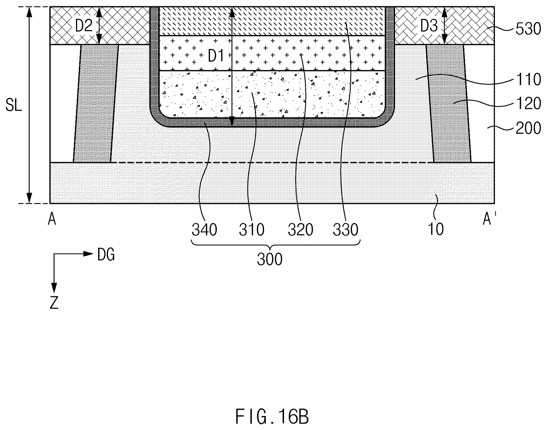

FIG. 16B is a cross-sectional view illustrating a structure of the semiconductor device taken along the line A-A' of FIG. 16A according to some embodiments of the present disclosure.

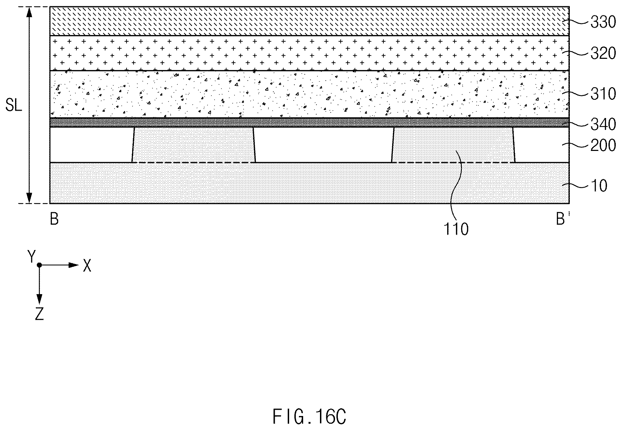

FIG. 16C is a cross-sectional view illustrating a structure of the semiconductor device taken along the line B-B' of FIG. 16A according to some embodiments of the present disclosure.

Referring to FIGS. 9, 10A, 16A, 16B, and 16C, a word-line trench (WT) may be formed to pass through the center of the plurality of active regions 100 and extend in the first direction (X). Thereafter, a word-line insulation layer 340 that contacts the bottom surface and side surfaces of the word-line trench (WT) and extends in the first direction (X) may be formed. Then, a first word-line electrode layer 310 extending in the first direction (X) may be formed on the word-line insulation layer 340. Thereafter, a second word-line electrode layer 320 extending in the first direction (X) may be formed on the first word-line electrode layer 310. Thereafter, a word-line capping layer 330 extending in the first direction (X) may be formed on the second word-line electrode layer 320.

The first depth(D1) is the depth by which the word-line structure 300 is recessed in the third direction (Z) from the surface of the semiconductor layer (SL). The second depth (D2) is the depth by which the bit-line pad region 430 is recessed in the third direction (Z) from the surface of the semiconductor layer (SL). The first depth(D1) may be deeper than the second depth (D2). The first depth (D1) may be deeper than a third depth (D3), which is the depth by which the storage-node pad region 530 is recessed in the third direction (Z) from the surface of the semiconductor layer (SL). The second depth (D2) and the third depth (D3) may be the same depth.

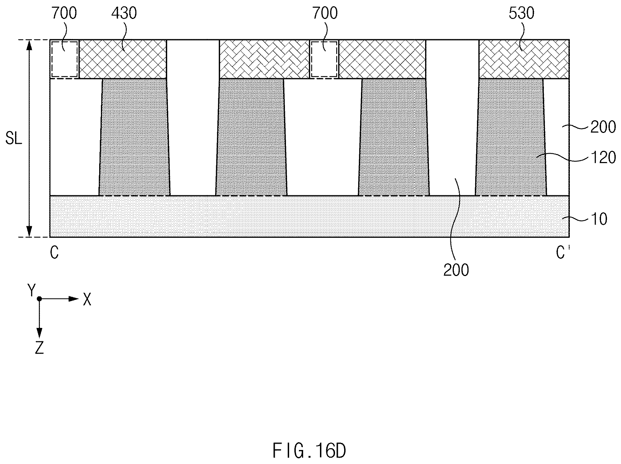

FIG. 16D is a cross-sectional view illustrating a structure of the semiconductor device taken along the line C-C' of FIG. 16A according to some embodiments of the present disclosure.

FIG. 16D may be the same or substantially the same cross-section as FIG. 15D. Referring to FIG. 16D, a pad layer (PAD) contacting one side (e.g., the left side in FIG. 16D) of a pad insulation region 700 may be used as the storage-node pad region 530. A pad layer (PAD) contacting the other side (e.g., the right side in FIG. 16D) of the pad insulation region 700 may be used as the bit-line pad region 430.

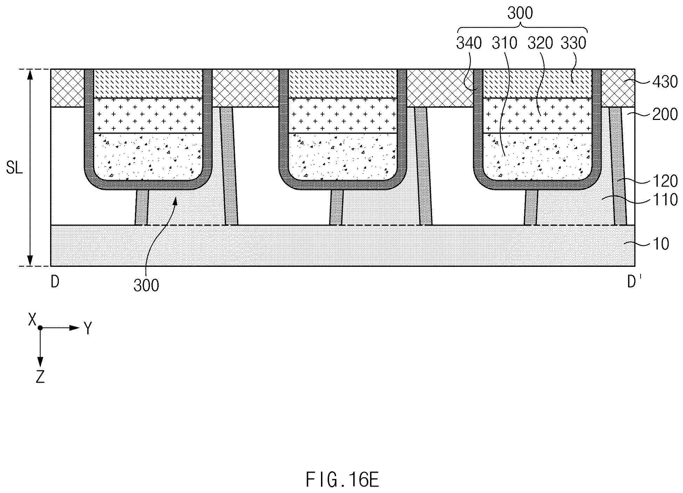

FIG. 16E is a cross-sectional view illustrating a structure of the semiconductor device taken along the line D-D' of FIG. 16A according to some embodiments of the present disclosure.

Referring to FIGS. 9, 10A, 16A, and 16E, the plurality of word-line structures 300 may be repeatedly arranged spaced apart from each other in the second direction (Y). One side of the word-line structure 300 may contact the bit-line pad region 430 that is in contact with the active region 100 that contacts the bottom surface and the side surfaces of the word-line structure 300.

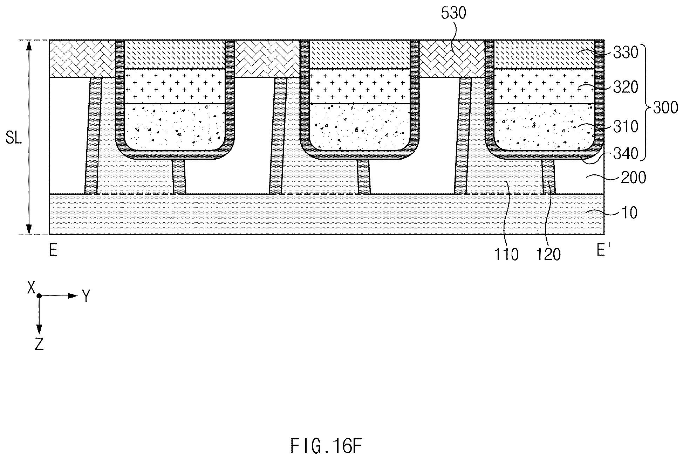

FIG. 16F is a cross-sectional view illustrating a structure of the semiconductor device taken along the line E-E' of FIG. 16A according to some embodiments of the present disclosure.

Referring to FIGS. 9, 10A, 16A, and 16F, the plurality of word-line structures 300 may be repeatedly arranged spaced apart from each other in the second direction (Y). One side of the word-line structure 300 may contact the storage-node pad region 530 that is in contact with the active region 100 that contacts the bottom surface and side surfaces of the word-line structure 300.

Referring to FIGS. 12A and 16A, when pad trenches (PTs) are formed, not only for a portion where the bit-line pad region 430 is to be formed, but also for another portion where the storage-node pad region 530 is to be formed, each of the trenches that can be formed is reduced in width. In addition, when considering a minimum pitch that can be processed, the etching process may be performed several times, which may cause unexpected problems such as increase in production costs and an increase in the number of process steps. However, when the pad trenches (PTs) are formed across a portion of each of two adjacent active regions 100 as shown in FIG. 12A to simultaneously form the pad layers (PADs), there is no concern about reaching limitations of the fabrication technology, and the etching process can be performed only once, resulting in reduction in production costs.

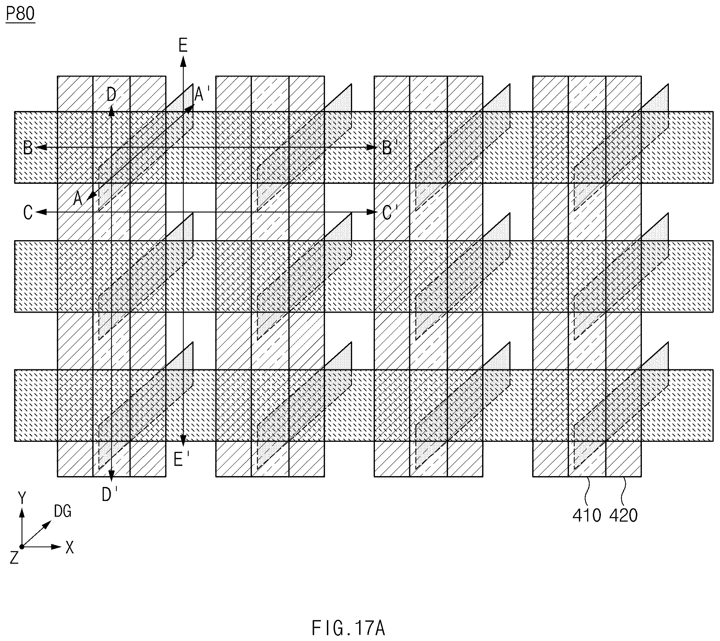

The following embodiments of FIGS. 17A to 17F will hereinafter be described with a focus on the characteristics that are different from those of FIGS. 16A to 16F.

FIG. 17A is a plan view illustrating a result of performing operation S80 of FIG. 9 according to some embodiments of the present disclosure.

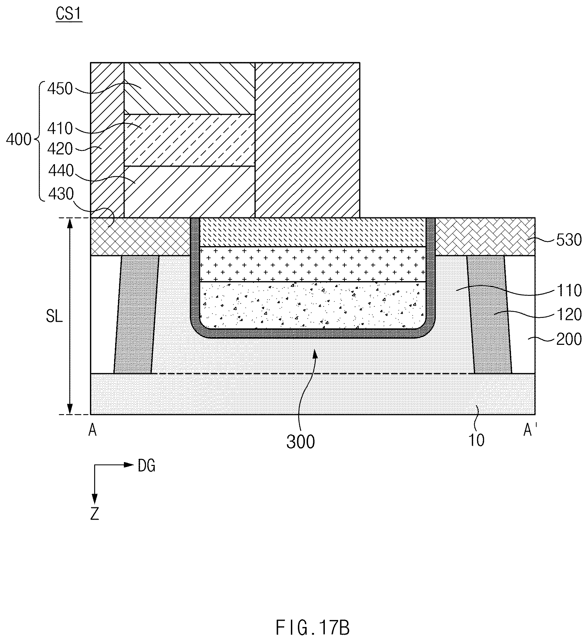

FIG. 17B is a cross-sectional view illustrating a structure of the semiconductor device taken along the line A-A' of FIG. 17A according to some embodiments of the present disclosure.

Referring to FIGS. 9, 10A, 17A, and 17B, the bit-line contact region 440 may be formed to contact the top surface of the bit-line pad region 430. Thereafter, the bit-line electrode layer 410 disposed on the bit-line contact region 440 may be formed. The bit-line electrode layer 410 may be formed to extend in the second direction (Y). Thereafter, the bit-line capping layer 450 disposed on the bit-line electrode layer 410 may be formed. The plurality of bit-line spacers 420 may be formed to contact both sides of each of the bit-line electrode layer 410, the bit-line contact region 440, and the bit-line contact capping layer 450.

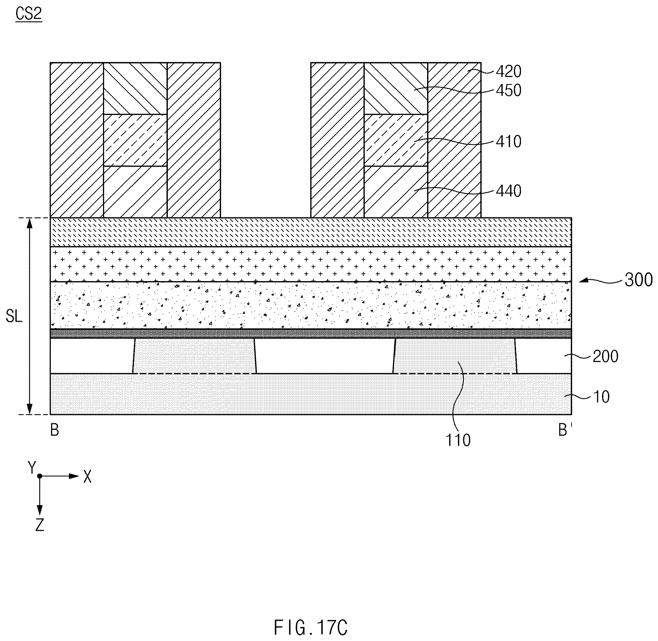

FIG. 17C is a cross-sectional view illustrating a structure of the semiconductor device taken along the line B-B' of FIG. 17A according to some embodiments of the present disclosure.

Referring to FIGS. 9, 10A, 17A, and 17C, the plurality of bit-line contact regions 440 may be formed spaced apart from each other in the first direction (X). The plurality of bit-line electrode layers 410 may be formed spaced apart from each other in the first direction (X). The plurality of bit-line capping layers 450 may be formed spaced apart from each other in the first direction (X). The plurality of bit-line spacers 420 may contact each of the side surfaces of the bit-line electrode layer 410 in the first direction (X), and may contact each of the side surfaces of the bit-line electrode layer 410 in a direction opposite to the first direction (X).

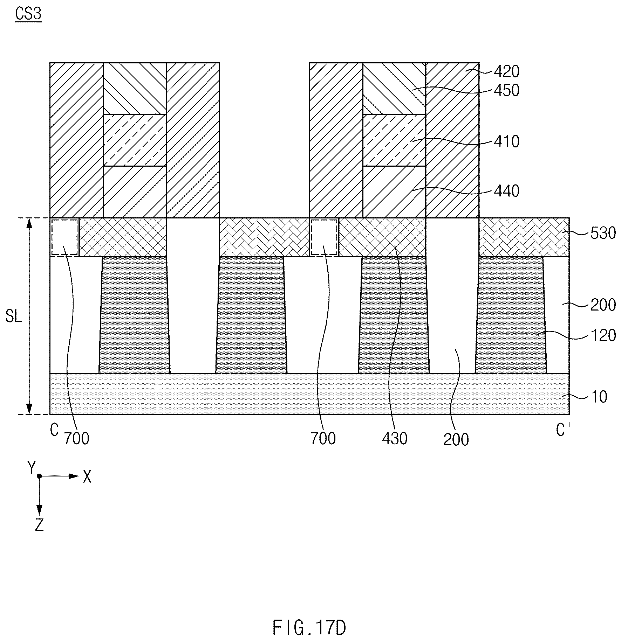

FIG. 17D is a cross-sectional view illustrating a structure of the semiconductor device taken along the line C-C' of FIG. 17A according to some embodiments of the present disclosure.

Referring to FIGS. 9, 10A, 17A, and 17D, a portion of the bit-line spacer 420 may be disposed on the pad insulation region 700. Another portion of the bit-line spacer 420 may be disposed on the cell isolation region 200.

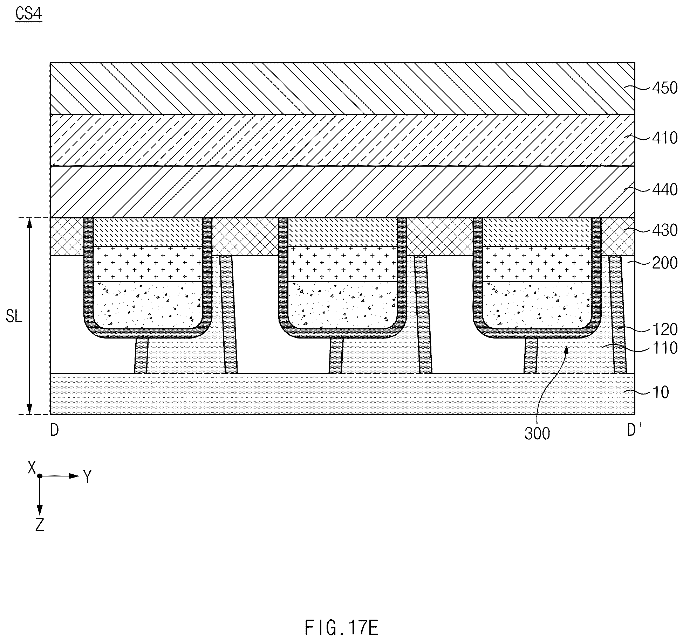

FIG. 17E is a cross-sectional view illustrating a structure of the semiconductor device taken along the line D-D' of FIG. 17A according to some embodiments of the present disclosure.

Referring to FIGS. 9, 10A, 17A, and 17E, each of the bit-line contact region 440, the bit-line electrode layer 410, the bit-line capping layer 450, and the bit-line spacer 420 may be formed to extend in the second direction (Y).

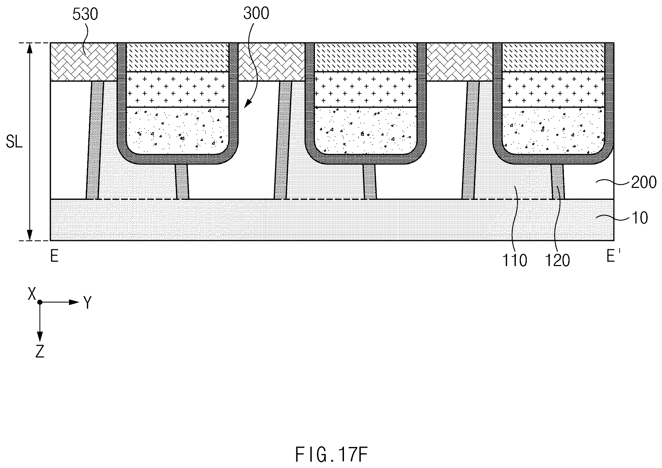

FIG. 17F is a cross-sectional view illustrating a structure of the semiconductor device taken along the line E-E' of FIG. 17A according to some embodiments of the present disclosure.

FIG. 17F may be the same or substantially the same cross-section as FIG. 16F.

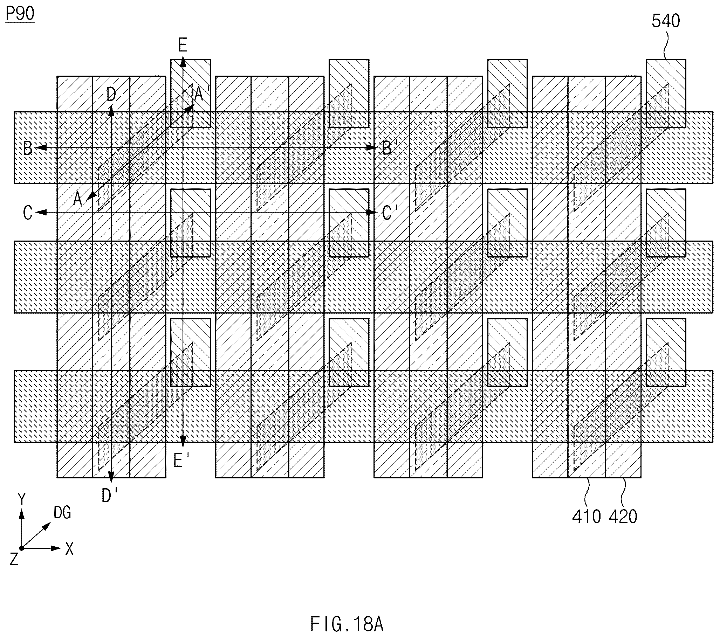

The following embodiments of FIGS. 18A to 18F will hereinafter be described with a focus on the characteristics that are different from those of FIGS. 17A to 17F.

FIG. 18A is a plan view illustrating a result of performing operation S90 of FIG. 9 according to some embodiments of the present disclosure.

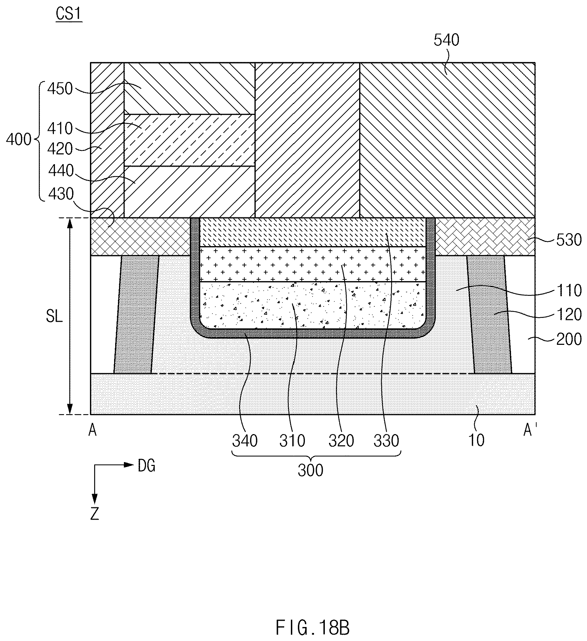

FIG. 18B is a cross-sectional view illustrating a structure of the semiconductor device taken along the line A-A' of FIG. 18A according to some embodiments of the present disclosure.

Referring to FIGS. 9, 10A, 18A, and 18B, each of the plurality of storage-node contact regions 540 may be formed to overlap with some parts of the active regions 100. One end of the active region 100 may be formed to overlap with the bit-line pad region 430. The other end of the active region 100 may be formed to overlap with the storage-node contact regions 540. Each of the storage-node contact regions 540 may contact the top surface of the storage-node pad region 530.

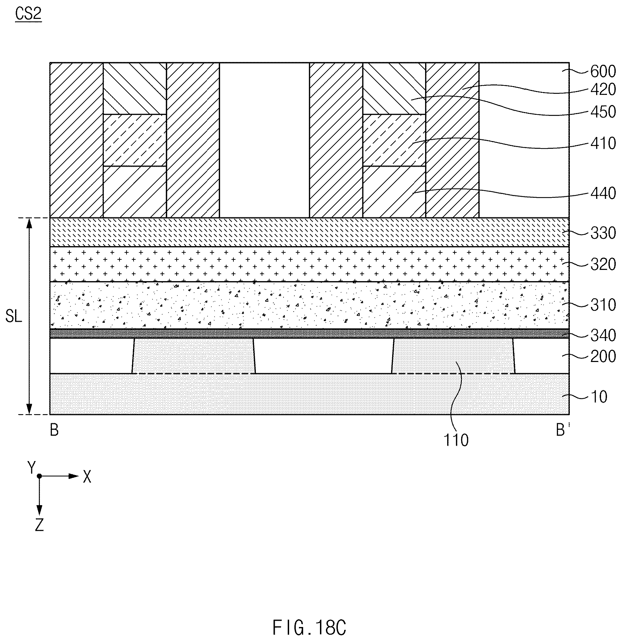

FIG. 18C is a cross-sectional view illustrating a structure of the semiconductor device taken along the line B-B' of FIG. 18A according to some embodiments of the present disclosure.

Referring to FIG. 18C, the plurality of contact insulation regions 600 may be disposed between the bit-line spacers 420. For example, the contact insulation regions 600 may contact the bit-line spacers 420 in the first direction (X). Also, the contact insulation regions 600 may contact the bit-line spacers 420 in a direction opposite to the first direction (X).

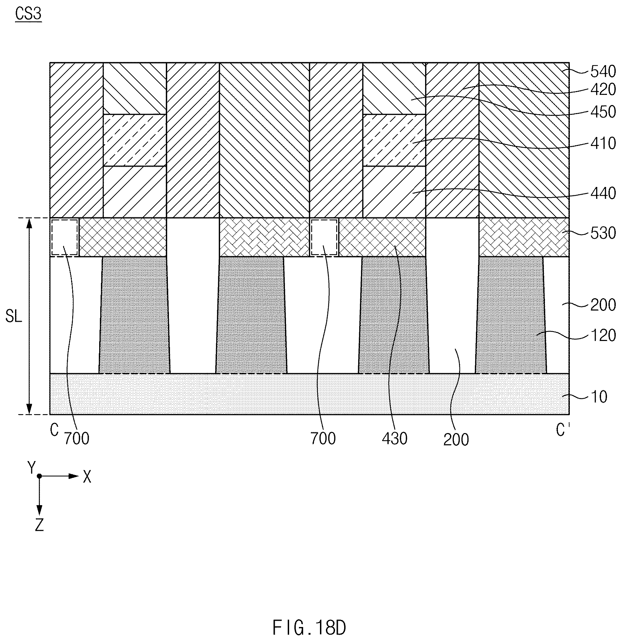

FIG. 18D is a cross-sectional view illustrating a structure of the semiconductor device taken along the line C-C' of FIG. 18A according to some embodiments of the present disclosure.

Referring to FIG. 18D, the plurality of storage-node contact regions 540 may be disposed between the bit-line spacers 420. For example, the storage-node contact regions 540 may contact the bit-line spacers 420 in the first direction (X). The storage-node contact regions 540 may contact the bit-line spacers 420 in a direction opposite to the first direction (X).

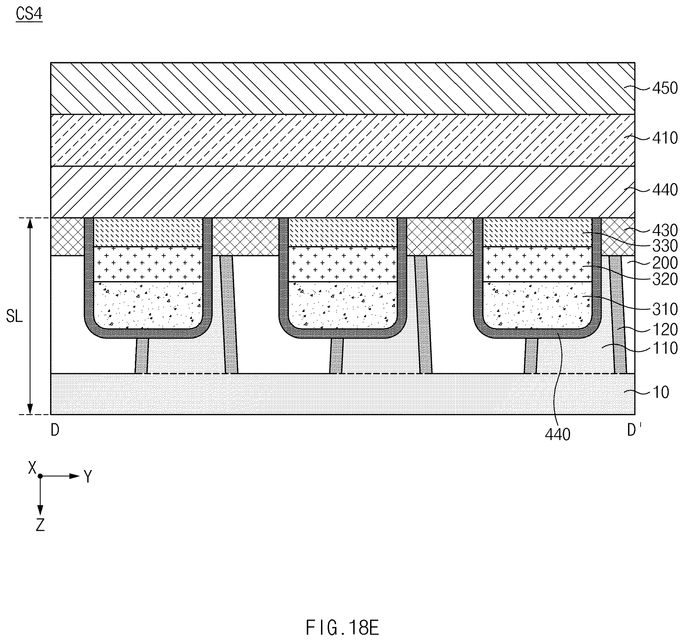

FIG. 18E is a cross-sectional view illustrating a structure of the semiconductor device taken along the line D-D' of FIG. 18A according to some embodiments of the present disclosure.

FIG. 18E may be the same or substantially the same cross-section as FIG. 17E.

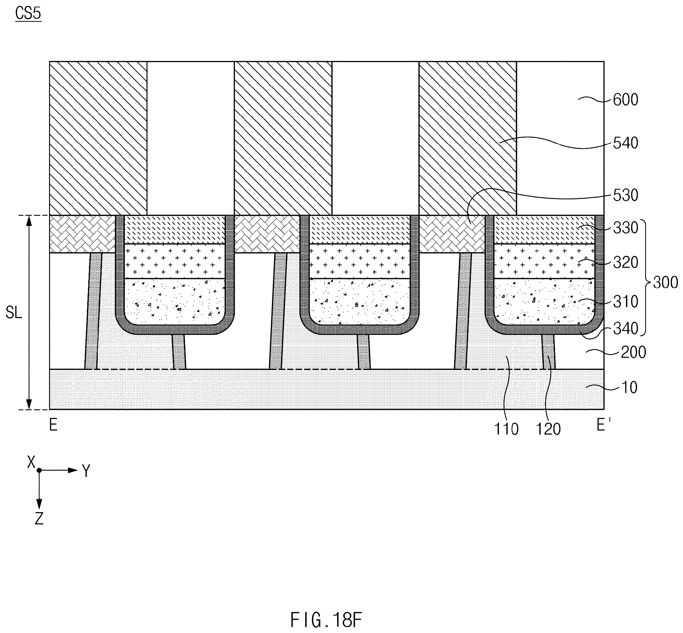

FIG. 18F is a cross-sectional view illustrating a structure of the semiconductor device taken along the line E-E' of FIG. 18A according to some embodiments of the present disclosure.

Referring to FIG. 18F, the plurality of storage-node contact regions 540 and the plurality of contact insulation regions 600 may be alternately and repeatedly formed in the second direction (Y). Two side surfaces of each of the plurality of storage-node contact regions 540 may contact the contact insulation region 600. Two side surfaces of each of the plurality of contact insulation regions 600 may contact the storage-node contact regions 540. For example, the storage-node contact regions 540 may contact the contact insulation regions 600 in the second direction (Y). The storage-node contact regions 540 may contact the contact insulation regions 600 in a direction opposite to the second direction (Y). In addition, the contact insulation regions 600 may contact the storage-node contact regions 540 in the second direction (Y). The contact insulation regions 600 may contact the storage-node contact regions 540 in a direction opposite to the second direction (Y).

As evident from the foregoing description, the semiconductor device, according to some embodiments of the present disclosure, can facilitate the fabrication process of bit-line contacts and storage-node contacts, thereby the required resistance is effectively secured. In addition, the semiconductor device according to some embodiments of the present disclosure includes a pad region disposed between the bit-line contact and the active region, and another pad region disposed between the storage-node contact and the active region, resulting in reduction in contact resistance. The method for manufacturing the semiconductor device according to some embodiments of the present disclosure can reduce production costs of the semiconductor device, and can simplify the fabrication process (i.e., can reduce the number of fabrication steps) of the semiconductor device.

The embodiments of the present disclosure provide a variety of advantageous effects capable of being directly or indirectly recognized by those with ordinary skill in the art from the present disclosure.

Those skilled in the art will appreciate that the embodiments of the present disclosure are not confined to the specific embodiments detailed herein and may be carried out in other specific ways than those set forth herein. Moreover, claims not explicitly presented in the appended claims may be strategically combined to form an embodiment or introduced as a new claim through subsequent amendments after the application has been filed.

Although a number of illustrative embodiments have been described, it should be understood that modifications and enhancements to the disclosed embodiments and other embodiments can be devised based on what is described and/or illustrated in the present disclosure. Furthermore, the embodiments may be combined to form additional embodiments.

## Claims

1. A semiconductor device comprising:
a semiconductor layer;
a first word-line structure recessed from a surface of the semiconductor layer into the semiconductor layer by a first depth, and configured to extend in a first direction;
a first active region disposed in the semiconductor layer and extending in a diagonal direction with respect to the first direction, and configured to overlap with the first word-line structure;
a first bit-line pad region configured to overlap with one end of the first active region and contact one side of the first word-line structure, and be recessed from the surface of the semiconductor layer into the semiconductor layer by a second depth shallower than the first depth; and
a first storage-node pad region configured to overlap with another end of the first active region and contact another side of the first word-line structure, and be spaced apart from the first bit-line pad region in the diagonal direction.

2. The semiconductor device according to claim 1, wherein the first storage-node pad region is recessed from the surface of the semiconductor layer by a third depth.

3. The semiconductor device according to claim 2, wherein the second depth is identical to the third depth.

4. The semiconductor device according to claim 1, further comprising:
a first bit-line contact region disposed on the surface of the semiconductor layer, and configured to contact the first bit-line pad region; and
a first storage-node contact region disposed on the surface of the semiconductor layer, and configured to contact the first storage-node pad region.

5. The semiconductor device according to claim 4, further comprising:
a first bit-line electrode layer disposed on the first bit-line contact region, configured to overlap with the first bit-line pad region, and extend in a second direction; and
a first bit-line spacer configured to contact both side surfaces of the first bit-line electrode layer, and extend in the second direction.

6. The semiconductor device according to claim 5, wherein the second direction is perpendicular to the first direction.

7. The semiconductor device according to claim 5, wherein:
an angle formed between the diagonal direction and the first direction is an acute angle; and
an angle formed between the diagonal direction and the second direction is an acute angle.

8. The semiconductor device according to claim 5, further comprising:
a second active region disposed in the semiconductor layer, configured to extend in the diagonal direction, be spaced apart from the first active region in the first direction, and overlap with the first word-line structure;
a second bit-line pad region configured to overlap with one end of the second active region and contact the one side of the first word-line structure, and be recessed from the surface of the semiconductor layer into the semiconductor layer by the second depth; and
a second storage-node pad region configured to overlap with another end of the second active region and contact the other side of the first word-line structure, and be spaced apart from the second bit-line pad region in the diagonal direction.

9. The semiconductor device according to claim 8, further comprising:
a second bit-line contact region disposed on the surface of the semiconductor layer, and configured to contact the second bit-line pad region; and
a second storage-node contact region disposed on the surface of the semiconductor layer, and configured to contact the second storage-node pad region.

10. The semiconductor device according to claim 9, further comprising:
a second bit-line electrode layer disposed on the second bit-line contact region, configured to overlap with the second bit-line pad region, and extend in a second direction; and
a second bit-line spacer configured to contact both side surfaces of the second bit-line electrode layer, and extend in the second direction.

11. A method for manufacturing a semiconductor device the method comprising:
forming a plurality of active regions that is arranged repeatedly spaced apart from each other in a first direction and a second direction within a semiconductor layer and extends in a diagonal direction with respect to the first direction;
forming a plurality of pad trenches, each of which overlaps the plurality of active regions spaced apart from each other in the first direction and extends in the second direction;
forming a plurality of pad regions, each of which contacts side surfaces of the plurality of pad trenches and extends in the second direction;
forming a plurality of pad insulation regions, each of which extends in the second direction at a central portion of the plurality of pad trenches and electrically isolates the plurality of pad regions from each other; and
forming a plurality of word-line structures that overlaps a central portion of the plurality of active regions arranged in the first direction, extends in the first direction, and is repeatedly spaced apart from each other in the second direction.

12. The method according to claim 11, wherein:
forming the plurality of word-line structures includes:
forming the plurality of word-line structures recessed from a surface of the semiconductor layer by a first depth, and
forming the plurality of pad trenches includes:
forming the plurality of pad trenches that is recessed from a surface of the semiconductor layer by a second depth shallower than the first depth.

13. The method according to claim 11, wherein forming the plurality of word-line structures includes:
removing a portion of each of the plurality of pad regions.

14. The method according to claim 11, further comprising:
forming a plurality of bit-line contact regions, each of which overlaps with one end of each of the plurality of active regions and is disposed on pad regions that contact one end of each of the plurality of word-line structures; and
forming a plurality of storage-node contact regions, each of which overlaps with another end of each of the plurality of active regions and is disposed on pad regions that contact another end of each of the plurality of word-line structures.

15. The method according to claim 11, further comprising:
forming a plurality of bit-line electrode layers that overlap with the plurality of bit-line contact regions, extend in the second direction, and are arranged repeatedly spaced apart from each other in the first direction.
